(19) Europäisches Patentamt
European Patent Office
Office européen des brevets

(11) EP 3 658 989 B1

(12) EUROPÄISCHE PATENTSCHRIFT

(45) Veröffentlichungstag und Bekanntmachung des Hinweises auf die Patenterteilung:
**05.05.2021 Patentblatt 2021/18**

(21) Anmeldenummer: **18745891.4**

(22) Anmeldetag: **23.07.2018**

(51) Int Cl.:
***G03F 7/00*** *(2006.01)* ***G03F 7/09*** *(2006.01)*
***G03F 7/11*** *(2006.01)* ***G03H 1/02*** *(2006.01)*
***G11B 7/245*** *(2006.01)*

(86) Internationale Anmeldenummer:
**PCT/EP2018/069888**

(87) Internationale Veröffentlichungsnummer:
**WO 2019/020553 (31.01.2019 Gazette 2019/05)**

# (54) SCHUTZSCHICHT FÜR PHOTOPOLYMER

PROTECTIVE LAYER FOR PHOTOPOLYMER

COUCHE PROTECTRICE POUR PHOTOPOLYMÈRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.07.2017 EP 17183344**

(43) Veröffentlichungstag der Anmeldung:
**03.06.2020 Patentblatt 2020/23**

(73) Patentinhaber: **Covestro Intellectual Property GmbH & Co. KG**
**51373 Leverkusen (DE)**

(72) Erfinder:
- **KOSTROMINE, Serguei**
**53913 Swisttal-Buschhofen (DE)**
- **RÖLLE, Thomas**
**51381 Leverkusen (DE)**
- **HOVESTADT, Wieland**
**42799 Leichlingen (DE)**
- **VETTERLE, Karl**
**51373 Leverkusen (DE)**
- **KLOBUTOWSKI, Therese**
**51375 Leverkusen (DE)**

(74) Vertreter: **Levpat**
**c/o Covestro AG**
**Gebäude 4825**
**51365 Leverkusen (DE)**

(56) Entgegenhaltungen:
**EP-A1- 0 940 720** **EP-A1- 2 613 318**
**WO-A1-2013/079422** **WO-A1-2017/081078**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 658 989 B1

## Beschreibung

Die Erfindung betrifft einen Schichtaufbau umfassend eine Photopolymerschicht B und eine zumindest teilweise gehärtete Schutzschicht C, ein Verfahren zur Herstellung des erfindungsgemäßen Schichtaufbaus, ein Kit-of-parts, die Verwendung einer zumindest teilweise gehärteten Schutzschicht C zum Schutz einer Photopolymerschicht B, sowie optische Anzeigen und Sicherheitsdokumente, umfassend den erfindungsgemäßen Schichtaufbau.

Photopolymerschichten zur Herstellung holographischer Medien sind grundsätzlich z.B. aus der WO 2011/054797 und der WO 2011/067057 bekannt. Vorteile dieser holographischen Medien sind deren hohe diffraktive Lichtbeugungseffizienz und eine vereinfachte Verarbeitung, da nach der holographischen Belichtung keine weiteren chemischen und / oder thermischen Entwicklungsschritte nötig sind.

Der holographische Film (Bayfol® HX der Fa. Covestro Deutschland AG) besteht aus einem Filmsubstrat (A) und einer lichtempfindlichen Photopolymerschicht (B). Optische Hologramme werden in der Schicht (B) durch lokale Photopolymerisation gebildet und durch flächige UV-VIS-Belichtung fixiert. So entsteht aus der Schicht (B) eine nicht mehr photoempfindliche durchpolymerisierte Schicht (B') mit einem vorher eingeschriebenen Hologramm. Dieses Hologramm ist zwar an sich auf Dauer sehr stabil, kann aber durch mechanische Einflüsse und / oder bei Kontakt mit z.B. organischen Substanzen (Lösungsmitteln) seine Eigenschaften verändern. Um diese äußeren Einflüsse auf die holographischen-optischen Eigenschaften zu reduzieren, ist das Aufbringen einer Schutzschicht eine denkbare Lösung und auch im Stand der Technik z.B. in der WO 2017081078 beschrieben.

Denkbare Schutz-Methoden sind dabei Lackieren, Laminieren, Aufkleben einer Schutzschicht und / oder einer Schutzfolie. Es entstehen jedoch mannigfaltige Probleme beim klassischen Lackieren oder bei dem Aufkleben verbunden mit flüssigen Lack und / oder Kleber-Komponenten, die bei dem Kontakt mit der (B')-Schicht das Hologramm ganz zerstören können. Zum festen Aufkleben von funktionalisierten Folien auf feste Substrate, wie beispielsweise Glas, verwendet man in der Regel speziell dafür entwickelte optisch klare Klebstofffilme ("OCA", optical clear adhesive).

Bei Experimenten wurde jedoch festgestellt, dass die Verwendung solcher Klebstoffschichten im Hologramm einen Farbshift erzeugt, wenn sie mit den oben genannten belichteten Photopolymerfilmen in Kontakt gebracht werden und dieses damit unbrauchbar machen. Besonders bei RGB-Hologrammen und vollfarbigen ("true colour") Hologrammen ist jedoch bereits eine geringe Wellenlängenverschiebung um > 20 nm ("Farbshift") problematisch, da der Gesamtfarbeindruck des Hologramms verfälscht wird. Aus diesem Grunde ist es nahezu unmöglich, die B-Schichten mit einem Hologramm auf einem Träger wie z.B. Glas fest aufzukleben und die bekannten Eigenschaften vollständig zu erhalten.

Aufgabe der vorliegenden Erfindung war es daher, einen Schichtverbund der eingangs erwähnten Art bereit zu stellen, der mit einem Substrat verklebt werden kann, ohne dass es zu einer Wellenlängenverschiebung von mehr als 20 nm bei einem in den Photopolymerfilm einbelichteten Hologramm kommt.

Die Aufgabe ist durch einen Schichtaufbau gelöst, welcher eine flächig vorliegende Photopolymerschicht B und eine zumindest teilweise gehärtete Schutzschicht C umfasst, wobei die Schutzschicht C erhältlich ist durch Umsetzung einer wässrigen Zusammensetzung umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid,

wobei die Photopolymerschicht B zumindest teilweise mit der Schicht C verbunden ist.

Überraschenderweise stellt die zumindest teilweise gehärtete Schutzschicht C eine Barriere-Schicht für die flüssigen organischen Komponenten des "OCA" dar, da diese Schicht für die Klebstoffkomponenten nicht durchlässig ist und so deren negativer Einfluss auf das Hologramm verhindert wird. Ferner wurde überraschend gefunden, dass diese Barriere-Schicht auch in Gegenrichtung wirkt, d.h. den Austritt und die mögliche Migration der Komponenten der Photopolymerschicht zur Klebstoffschicht ebenfalls unterbindet, was für die Gesamtstabilität des Hologramms entscheidend beiträgt.

Des Weiteren ist es möglich, die Schutzschicht C als wässrige Formulierung auf eine unbelichtete oder belichtete Photopolymerschicht aufzubringen. Die erfindungsgemäße Schicht C beeinflusst in keiner Weise den Schreibprozess der Hologramme in der Photopolymerschicht und reduziert deren Qualität nicht. Die Photoempfindlichkeit des erfindungsgemäßen Schichtaufbaus, wie die Intensität und auch die spektrale Lage des Hologramms, unterscheidet sich kaum von den Werten für die ursprüngliche Photopolymerschicht B ohne jegliche Barriereschicht bzw. Schutzschicht C. Der erfindungsgemäße Schichtaufbau ermöglicht es, einen kommerziellen OCA eigener Wahl (Schicht D) zu verwenden um das Photopolymer mit einem festen Träger (Schicht E), wie beispielsweise Glas, zu verkleben.

Durch die erfindungsgemäße Schutzschicht C wird die Photopolymerschicht B gegen physikalische und chemische Einflüsse, wie Kratz- und Lösungsmittelschäden bei gleichzeitiger guter Haftung der Schichten des Aufbaus

untereinander und Biegsamkeit sowie Elastizität des erfindungsgemäßen Schichtaufbaus geschützt.

Unter "flächig vorliegend" im Sinne der Erfindung wird eine Ausgestaltung als ebene Fläche oder auch als konkav oder konvex gewölbte oder wellige Fläche verstanden. Im Sinne der Erfindung muss das das Hologramm enthaltende Photopolymer B insofern eine ebene, gewölbte oder gewellte Fläche aufweisen, damit eine Auflaminierung der Versiegelungsschicht zumindest im Bereich des Hologramms möglich wird.

Das Wort "ein" im Zusammenhang mit zählbaren Größen ist im Rahmen der vorliegenden Erfindung nur dann als Zahlwort zu verstehen, wenn dies ausdrücklich gesagt wird (z. B. durch den Ausdruck "genau ein"). Wenn im Folgenden beispielsweise von "einem Polyisocyanat" gesprochen wird, ist das Wort "ein" lediglich als unbestimmter Artikel und nicht als Zahlwort aufzufassen, es ist also damit auch eine Ausführungsform umfasst, in der zwei oder mehr Polyisocyanate vorhanden sind die sich beispielsweise strukturell unterscheiden.

In einer bevorzugten Ausführungsform ist die Photopolymerschicht B eine unbelichtete Photopolymerschicht umfassend

I) Matrixpolymere,
II) Schreibmonomere,
III) Photoinitiatoren,
IV) gegebenenfalls mindestens eine nicht photopolymerisierbare Komponente, und
V) gegebenenfalls Katalysatoren, Radikalstabilisatoren, Lösungsmittel, Additive sowie andere Hilfs- und / oder Zusatzstoffe,

oder die Photopolymerschicht B ist eine teilbelichtete Photopolymerschicht, enthaltend ein Hologramm, vorzugsweise ein Volumenhologramm, wobei das Volumenhologramm vorzugsweise ausgewählt ist aus der Gruppe bestehend aus In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen und holographischen Stereogrammen.

Vorzugsweise ist in den erfindungsgemäßen Schichtaufbau wenigstens ein Hologramm einbelichtet.

Die spektrale Verschiebung des Transmissionsspektrums ist definiert als Differenz ($\Delta\lambda$) aus der Wellenlänge des einschreibenden Lasers ($\lambda_w$) und dem spektralen Peak des eingeschriebenen Hologramm($\lambda_{peak}$) (ISO-Norm 17901-1:2015(E)):

$$\Delta\lambda = \lambda_{peak} - \lambda_w \qquad (1)$$

Vorzugsweise beträgt $\Delta\lambda$ des eingeschriebenen Hologramms im erfindungsgemäßen Schichtaufbau B'-C, A-B'-C, B'-C-D, A-B'-C-D, B'-C-D-E oder A-B'-C-D-E +/- 10 nm, bevorzugter +/-5 nm, besonders bevorzugt +/-3 nm, wobei B' eine zumindest teilbelichtete Photopolymerschicht mit eingeschriebenem Hologramm ist.

In einer bevorzugten Ausführungsform enthält der erfindungsgemäße Schichtaufbau weiterhin eine Substratschicht A, wobei die Photopolymerschicht B auf einer Seite zumindest teilweise mit der Substratschicht A verbunden ist und auf der gegenüberliegenden Seite zumindest teilweise mit der Schutzschicht C verbunden ist.

In einer bevorzugten Ausführungsform enthält der erfindungsgemäße Schichtaufbau weiterhin eine Klebstoffschicht D, wobei die Schutzschicht C auf einer Seite zumindest teilweise mit der Klebstoffschicht D verbunden ist und auf der gegenüberliegenden Seite zumindest teilweise mit der Photopolymerschicht B verbunden ist, wobei die Klebstoffschicht D vorzugsweise eine optical clear adhesive-Klebstoffschicht ist.

In einer bevorzugten Ausführungsform des erfmdungsgemäßen Schichtaufbaus liegt die Photopolymerschicht B auf einer Substratschicht A vor, wobei die Photopolymerschicht B auf einer Seite zumindest teilweise mit der Substratschicht A verbunden ist und die Photopolymerschicht B auf der gegenüberliegenden Seite zumindest teilweise mit der Schutzschicht C verbunden ist, und die Schutzschicht C auf einer Klebstoffschicht D vorliegt, wobei die Schutzschicht C auf einer Seite zumindest teilweise mit der Klebstoffschicht D verbunden ist und die Schutzschicht C auf der gegenüberliegenden Seite zumindest teilweise mit der Photopolymerschicht B verbunden ist. Die Schichten sind dabei in der Reihenfolge A-B-C-D angeordnet. Die Photopolymerschicht B kann eine unbelichtete, teilbelichtete oder belichtete Photopolymerschicht sein. Die teilbelichtete oder belichtete Photopolymerschicht kann ein Hologramm der oben genannten Art enthalten.

In einer bevorzugten Ausführungsform enthält der erfindungsmäße Schichtaufbau weiterhin eine Substratschicht E, wobei die Klebstoffschicht D auf einer Seite zumindest teilweise mit der Substratschicht E verbunden ist und auf der gegenüberliegenden Seite zumindest teilweise mit Schutzschicht C verbunden ist, wobei die Substratschicht vorzugsweise Glas ist.

In einer bevorzugten Ausführungsform des erfindungsgemäßen Schichtaufbaus liegt die Photopolymerschicht B auf einer Substratschicht A vor, wobei die Photopolymerschicht B auf einer Seite zumindest teilweise mit der Substratschicht A verbunden ist und die Photopolymerschicht B auf der gegenüberliegenden Seite zumindest teilweise mit der Schutzschicht C verbunden ist, und die Schutzschicht C auf einer Klebstoffschicht D vorliegt, wobei die Schutzschicht C auf einer Seite zumindest teilweise mit der Klebstoffschicht D verbunden ist und die Schutzschicht C auf der gegenüberliegenden Seite zumindest teilweise mit der Photopolymerschicht B verbunden ist und die Klebstoffschicht D auf einer Substratschicht E vorliegt, wobei die Klebstoffschicht D auf einer Seiter zumindest teilweise mit der Schutzschicht C verbunden ist und die Klebstoffschicht D auf der gegenüberliegenden Seiten zumindest teilweise mit der Substratschicht E verbunden ist. Die Schichten sind dabei in der Reihenfolge A-B-C-D-E angeordnet. Die Photopolymerschicht B kann eine unbelichtete, teilbelichtete oder belichtete Photopolymerschicht sein. Die teilbelichtete oder belichtete Photopolymerschicht kann ein Hologramm oder der genannte Art enthalten. Die Substratschicht E ist vorzugweise Glas.

In einer weiteren Ausführungsform des erfindungsgemäßen Schichtaufbaus ist die Rückseite der Photopolymerschicht B zumindest teilweise mit einer zweiten zumindest teilweise gehärteten Schutzschicht C verbunden, wobei die Schichten in der Reihenfolge C-B-C unmittelbar aufeinander angeordnet sind.

In einer weiteren Ausführungsform des erfindungsgemäßen Schichtaufbaus ist die Rückseite der Photopolymerschicht B zumindest teilweise mit einer zweiten zumindest teilweise gehärteten Schutzschicht C verbunden und die erste und zweite Schutzschicht C sind auf den der Photopolymerschicht gegenüberliegenden Seiten jeweils zumindest teilweise mit einer Klebstoffschicht D verbunden, wobei die Schichten in der Reihenfolge D-C-B-C-D angeordnet sind.

In einer weiteren Ausführungsform des erfindungsgemäßen Schichtaufbaus ist die Rückseite der Photopolymerschicht B zumindest teilweise mit einer zweiten zumindest teilweise gehärteten Schutzschicht C verbunden, wobei die erste und zweite Schutzschicht C auf den der Photopolymerschicht B gegenüberliegenden Seiten jeweils zumindest teilweise mit einer Klebstoffschicht D verbunden sind und die erste und zweite Klebstoffschicht D auf den der Schutzschicht C gegenüberliegenden Seiten jeweils zumindest teilweise mit einer Substratschicht D verbunden sind, wobei die Schichten in der Reihenfolge E-D-C-B-C-D-E angeordnet sind. Die Substratschicht E ist vorzugweise Glas.

In den oben genannten Ausführungsformen des erfindungsgemäßen Schichtaufbaus kann die zweite Schutzschicht C identisch oder verschieden von der ersten Schutzschicht C sein, die zweite Klebstoffschicht D kann identisch oder verschieden von der ersten Klebstoffschicht D sein, die zweite Substratschicht E kann identisch oder verschieden von der ersten Substratschicht E sein, die Photopolymerschicht B kann eine unbelichtete, teilbelichtete oder belichtete Photopolymerschicht sein und die teilbelichtete oder belichtete Photopolymerschicht kann ein Hologramm der oben genannte Art enthalten.

In einer bevorzugten Ausführungsform des erfindungsgemäßen Schichtaufbaus weist der mindestens eine Polyvinylalkohol nach DIN 53015:2001-02 als 4 Gew.-%-ige Lösung in Wasser bei 20° C eine Viskosität von $\geq$ 25 mPa*s, vorzugsweise $\geq$ 50 mPa*s auf.

In einer bevorzugten Ausführungsform des erfindungsgemäßen Schichtaufbaus weist der Polyvinylalkohol nach DIN EN ISO 3681:2007-10-01 einen Hydrolysegrad von $\geq$ 85 mol-%, bevorzugter $\geq$ 95 mol-% auf.

In einer bevorzugten Ausführungsform des erfindungsgemäßen Schichtaufbaus ist der Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon.

In einer bevorzugten Ausführungsform des erfindungsgemäßen Schichtaufbaus beträgt das Gewichtsverhältnis der jeweils eingesetzten Gesamtmenge von dem mindestens einen Polyvinylalkohol zu dem mindestens einen Vernetzer von 70:30 bis 90:10, bevorzugter von 75:25 bis 80:20, noch bevorzugter von 75:25 bis 82:18.

In einer bevorzugten Ausführungsform des erfindungsgemäßen Schichtaufbaus weist die gehärtete Schutzschicht C eine Schichtdicke von 3 $\mu$m bis 30 $\mu$m, bevorzugt 5 $\mu$m bis 15 $\mu$m auf.

In einer bevorzugten Ausführungsform des erfindungsgemäßen Schichtaufbaus umfasst der Schichtaufbau eine flächig vorliegende Photopolymerschicht B und eine zumindest teilweise gehärtete Schutzschicht C umfasst, wobei die Schutzschicht C erhältlich ist durch Umsetzung einer wässrigen Zusammensetzung umfassend

(I) mindestens einen Polyvinylalkohol, der nach DIN 53015:2001-02 als 4 Gew.-%ige Lösung in Wasser bei 20° C eine Viskosität von $\geq$ 25 mPa*s, vorzugsweise $\geq$ 50 mPa*s aufweist,
(II) mindestens einen Vernetzer für Polyvinylalkohole ausgewählt ist aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid,

wobei die Photopolymerschicht B zumindest teilweise mit der Schicht C verbunden ist.

In einer bevorzugten Ausführungsform des erfindungsgemäßen Schichtaufbaus umfasst der Schichtaufbau eine flächig vorliegende Photopolymerschicht B und eine zumindest teilweise gehärtete Schutzschicht C, wobei die Schutzschicht C erhältlich ist durch Umsetzung einer wässrigen Zusammensetzung umfassend

(I) mindestens einen Polyvinylalkohol,
(II) mindestens einen Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid,

wobei die Photopolymerschicht B zumindest teilweise mit der Schicht C verbunden ist und der Schichtaufbau weiterhin eine Klebstoffschicht D enthält, wobei die Schutzschicht C auf einer Seite zumindest teilweise mit der Klebstoffschicht D verbunden ist und auf der gegenüberliegenden Seite zumindest teilweise mit der Photopolymerschicht B verbunden ist.

In einer bevorzugten Ausführungsform des erfindungsgemäßen Schichtaufbaus umfasst der Schichtaufbau eine flächig vorliegende Photopolymerschicht B und eine zumindest teilweise gehärtete Schutzschicht C, wobei die Schutzschicht C erhältlich ist durch Umsetzung einer wässrigen Zusammensetzung umfassend

(I) mindestens einen Polyvinylalkohol, der nach DIN 53015:2001-02 als 4 Gew.-%ige Lösung in Wasser bei 20° C eine Viskosität von ≥ 25 mPa*s, vorzugsweise ≥ 50 mPa*s aufweist,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid,

wobei die Photopolymerschicht B zumindest teilweise mit der Schicht C verbunden ist und der Schichtaufbau weiterhin eine Klebstoffschicht D enthält, wobei die Schutzschicht C auf einer Seite zumindest teilweise mit der Klebstoffschicht D verbunden ist und auf der gegenüberliegenden Seite zumindest teilweise mit der Photopolymerschicht B verbunden ist.

In einer bevorzugten Ausführungsform des erfindungsgemäßen Schichtaufbaus umfasst der Schichtaufbau eine flächig vorliegende Photopolymerschicht B und eine zumindest teilweise gehärtete Schutzschicht C, wobei die Schutzschicht C erhältlich ist durch Umsetzung einer wässrigen Zusammensetzung umfassend

(I) mindestens einen Polyvinylalkohol der nach DIN 53015:2001-02 als 4 Gew.-%ige Lösung in Wasser bei 20° C eine Viskosität von ≥ 25 mPa*s, vorzugsweise ≥ 50 mPa*s aufweist,
(II) mindestens einen Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid,

wobei die Photopolymerschicht B zumindest teilweise mit der Schicht C verbunden ist und der Schichtaufbau weiterhin eine Klebstoffschicht D enthält, wobei die Schutzschicht C auf einer Seite zumindest teilweise mit der Klebstoffschicht D verbunden ist und auf der gegenüberliegenden Seite zumindest teilweise mit der Photopolymerschicht B verbunden ist.

Ebenfalls Gegenstand der Erfindung ist ein Kit-of-parts enthaltend mindestens eine flächig vorliegende Photopolymerschicht und eine wässrige Zusammensetzung zur Erzeugung einer zumindest teilweise gehärteten Schutzschicht C, wobei die wässrige Zusammensetzung

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und

(IV) gegebenenfalls mindestens ein Tensid umfasst und

wobei die Photopolymerschicht B gegebenenfalls auf einer Substratschicht A vorliegt.

In einer bevorzugten Ausführungsform des erfindungsgemäßen Kit-of-parts enthält das Kit-of-parts weiterhin eine Klebstoffschicht D.

In einer bevorzugten Ausführungsform des erfindungsgemäßen Kit-of-parts enthält das Kit-of-parts weiterhin eine Substratschicht E, vorzugsweise Glas.

In einer bevorzugten Ausführungsform des erfindungsgemäßen Kit-of-parts enthält das Kit-of-parts weiterhin eine Klebstoffschicht D und eine Substratschicht E, wobei die Klebstoffschicht D vorzugweise eine optical clear adhesive-Klebstoffschicht ist und das Substrat E Glas.

In einer bevorzugten Ausführungsform des erfindungsgemäßen Kit-of-parts ist die Photopolymerschicht B eine unbelichtete Photopolymerschicht umfassend

I) Matrixpolymere,
II) Schreibmonomere,
III) Photoinitiatoren,
IV) gegebenenfalls mindestens eine nicht photo polymerisierbare Komponente, und
V) gegebenenfalls Katalysatoren, Radikalstabilisatoren, Lösungsmittel, Additive sowie andere Hilfs- und / oder Zusatzstoffe,

oder die Photopolymerschicht B ist eine teilbelichtete Photopolymerschicht, enthaltend ein Hologramm, vorzugsweise ein Volumenhologramm, wobei das Volumenhologramm vorzugsweise ausgewählt ist aus der Gruppe bestehend aus In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen und holographischen Stereogrammen.

In einer bevorzugten Ausführungsform des erfindungsgemäßen Kit-of-parts weist der mindestens eine Polyvinylalkohol nach DIN 53015:2001-02 als 4 Gew.-%ige Lösung in Wasser bei 20° C eine Viskosität von ≥ 25 mPa*s, vorzugsweise ≥ 50 mPa*s auf.

In einer bevorzugten Ausführungsform des erfindungsgemäßen Kit-of-parts weist der Polyvinylalkohol nach DIN EN ISO 3681:2007-10-01 einen Hydrolysegrad von ≥ 85 mol-%, bevorzugter ≥ 95 mol-% auf.

In einer bevorzugten Ausführungsform des erfindungsgemäßen Kit-of-parts ist der Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon.

In einer bevorzugten Ausführungsform des erfindungsgemäßen Kit-of-parts beträgt das Gewichtsverhältnis der jeweils eingesetzten Gesamtmenge von dem mindestens einen Polyvinylalkohol zu dem mindestens einen Vernetzer von 70:30 bis 90:10, bevorzugter von 75:25 bis 80:20, noch bevorzugter von 75:25 bis 82:18.

In einer bevorzugten Ausführungsform des erfindungsgemäßen Kit-of-parts weist die gehärtete Schutzschicht C eine Schichtdicke von 3 μm bis 30 μm, bevorzugt 5 μm bis 15 μm auf.

In einer bevorzugten Ausführungsform des erfindungsgemäßen Kit-of-parts enthält das Kit-of-parts mindestens eine flächig vorliegende Photopolymerschicht und eine wässrige Zusammensetzung zur Erzeugung einer zumindest teilweise gehärteten Schutzschicht C, wobei die wässrige Zusammensetzung

(I) mindestens einen Polyvinylalkohol, der nach DIN 53015:2001-02 als 4 Gew.-%ige Lösung in Wasser bei 20° C eine Viskosität von ≥ 25 mPa*s, vorzugsweise ≥ 50 mPa*s aufweist,
(II) mindestens einen Vernetzer für Polyvinylalkohole ausgewählt ist aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid umfasst und

wobei die Photopolymerschicht B gegebenenfalls auf einer Substratschicht A vorliegt.

In einer bevorzugten Ausführungsform des erfindungsgemäßen Kit-of-parts enthält das Kit-of-parts mindestens eine flächig vorliegende Photopolymerschicht, eine Klebstoffschicht D, eine Substratschicht E und eine wässrige Zusammensetzung zur Erzeugung einer zumindest teilweise gehärteten Schutzschicht C, wobei die wässrige Zusammensetzung

(I) mindestens einen Polyvinylalkohol, der nach DIN 53015:2001-02 als 4 Gew.-%ige Lösung in Wasser bei 20° C eine Viskosität von ≥ 25 mPa*s, vorzugsweise ≥ 50 mPa*s aufweist,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid umfasst und

wobei die Photopolymerschicht B gegebenenfalls auf einer Substratschicht A vorliegt.

In einer bevorzugten Ausführungsform des erfindungsgemäßen Kit-of-parts enthält das Kit-of-parts mindestens eine flächig vorliegende Photopolymerschicht, eine Klebstoffschicht D, vorzugweise eine optical clear adhesive-Klebstoffschicht, eine Substratschicht E, vorzugsweise Glas, und eine wässrige Zusammensetzung zur Erzeugung einer zumindest teilweise gehärteten Schutzschicht C, wobei die wässrige Zusammensetzung

(I) mindestens einen Polyvinylalkohol,
(II) mindestens einen Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid umfasst und

wobei die Photopolymerschicht B gegebenenfalls auf einer Substratschicht A vorliegt.

Ebenfalls Gegenstand der Erfindung ist ein Verfahren zur Herstellung des erfindungsgemäßen Schichtaufbaus, dadurch gekennzeichnet, dass zunächst eine zumindest teilweise gehärtete Schutzschicht C auf eine Photopolymerschicht B aufgebracht wird, wobei die Photopolymerschicht B gegebenenfalls auf einer Substratschicht A vorliegt, um einen Schichtverbund B-C bzw. A-B-C zu ergeben, wobei die Schutzschicht C durch Umsetzung einer wässrigen Zusammensetzung umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid

erhältlich ist.

In einer bevorzugten Ausführungsform des erfindungsgemäßen Verfahrens wird in einem weiteren nachfolgenden Schritt eine Klebstoffschicht D auf die zumindest teilweise gehärtete Schutzschicht C aufgebracht, um einen Schichtverbund B-C-D bzw. A-B-C-D zu ergeben und danach in einem weiteren darauffolgenden Schritt eine Substratschicht E auf die Klebstoffschicht D aufgebracht wird, um einen Schichtverbund B-C-D-E bzw. A-B-C-D-E zu ergeben.

In einer bevorzugten Ausführungsform des erfindungsgemäßen Verfahrens wird in den Schichtverbund B-C, A-B-C, B-C-D, A-B-C-D, B-C-D-E oder A-B-C-D-E ein Hologramm einbelichtet und fixiert.

In einer weiteren bevorzugten Ausführung des erfindungsgemäßen Verfahrens umfasst dieses die folgenden Schritte:

- Herstellen einer lichtempfindlichen holographischen Folie mit dem Schichtaufbau A-B, umfassend:

  o Vorbereitung eines Beschichtungsmittel für die Herstellung der Photopolymerschicht B;

  o Beschichtung des Substrates A mit diesem Beschichtungsmittel, sodass der Schichtverbund A-B entsteht;

- Herstellen einer holographischen Folie mit dem Schichtaufbau A-B-C, umfassend:

  o Vorbereitung eines wässrigen Beschichtungsmittel für die Herstellung der Schutzschicht C umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid

o Beschichtung der Photopolymerschicht B des Schichtaufbaus A-B mit diesem Beschichtungsmittel, sodass der Schichtverbund A-B-C entsteht;

◦ Trocknen des Schichtverbundes A-B-C;

◦ ggf. Einschreiben eines Hologramms in die Photopolymerschicht B des Schichtverbundes A-B-C, sodass der Schichtverbund A-B*-C entsteht, wobei B* eine Photopolymerschicht mit einem eingeschriebenen Hologramm ist;

◦ ggf. Fixieren des Hologramms in der Photopolymerschicht B* durch flächige breitbandige UV/VIS-Belichtung des ganzen Schichtaufbaus A-B*-C mit einer Lichtenergie-Dosis von 5-10 J/cm$^2$; sodass der Schichtverbund A-B'-C entsteht, wobei B' die geblichene, durchpolymerisierte und nicht mehr photoempfindliche Photopolymerschicht B mit einem fixiertem Hologramm ist;

- Herstellen einer holographischen Folie mit dem Schichtaufbau A-B-C-D bzw. A-B'-C-D, umfassend:

◦ Aufbringen der Klebstoffschicht D auf die Schutzschicht C des Schichtaufbaus AB-C bzw. A-B'-C, sodass der Schichtverbund A-B-C-D bzw. A-B'-C-D entsteht;

◦ ggf. Einschreiben eines Hologramms in die Photopolymerschicht B des Schichtverbundes A-B-C-D, sodass der Schichtverbund A-B*-C-D entsteht, wobei B* eine Photopolymerschicht mit einem eingeschriebenen Hologramm ist;

◦ ggf. Fixieren des Hologramms in der Photopolymerschicht B* durch flächige breitbandige UV/VIS-Belichtung des ganzen Schichtaufbaus A-B*-C-D mit einer Lichtenergie-Dosis von 5-10 J/cm$^2$; sodass der Schichtverbund A-B'-C-D entsteht, wobei B' die geblichene, durchpolymerisierte und nicht mehr photoempfindliche Photopolymerschicht B mit einem fixiertem Hologramm ist;

- Herstellen einer holographischen Folie mit dem Schichtaufbau A-B-C-D-E bzw. A-B'-CD-E, umfassend:

◦ Aufbringen der Substratschicht E auf den Schichtaufbaus A-B-C-D bzw. A-B'-CD, sodass der Schichtverbund A-B-C-D-E bzw. A-B'-C-D-E entsteht;

◦ ggf. Einschreiben eines Hologramms in die Photopolymerschicht B des Schichtverbundes A-B-C-D-E, sodass der Schichtverbund A-B*-C-D-E entsteht, wobei B* eine Photopolymerschicht mit einem eingeschriebenen Hologramm ist;

◦ ggf. Fixieren des Hologramms in der Photopolymerschicht B* durch flächige breitbandige UV/VIS-Belichtung des ganzen Schichtaufbaus A-B*-C-D-E mit einer Lichtenergie-Dosis von 5 - 10 J/cm$^2$; sodass der Schichtverbund A-B'-C-D-E entsteht, wobei B' die geblichene, durchpolymerisierte und nicht mehr photoempfindliche Photopolymerschicht B mit einem fixiertem Hologramm ist.

In einer weiteren bevorzugten Ausführung des erfindungsgemäßen Verfahrens umfasst dieses die folgenden Schritte:

- Herstellen einer holographischen Folie mit dem Schichtaufbau A-B'-C, umfassend:

◦ Vorbereitung eines Beschichtungsmittel für die Herstellung der Photopolymerschicht B;

◦ Beschichtung des Substrates A mit diesem Beschichtungsmittel, sodass der Schichtverbund A-B entsteht;

◦ Vorbereitung eines wässrigen Beschichtungsmittel für die Herstellung der Schutzschicht C umfassend

(I) mindestens einen Polyvinylalkohol,

(II) mindestens einen Vernetzer für Polyvinylalkohole,

(III) gegebenenfalls mindestens einen Haftvermittler, wobei der Haftvermittler vorzugsweise mindestens ein Hydrolysat eines Aminoalkyl-trialkoxyilans ist, und

(IV) gegebenenfalls mindestens ein Tensid

◦ Beschichtung der Photopolymerschicht B des Schichtaufbaus A-B mit diesem Beschichtungsmittel, sodass der Schichtverbund A-B-C entsteht;

◦ Trocknen des Schichtverbundes A-B-C;

◦ Einschreiben eines Hologramms in die Photopolymerschicht B des Schichtverbundes A-B-C, sodass der Schichtverbund A-B*-C entsteht, wobei B* eine Photopolymerschicht mit einem eingeschriebenen Hologramm ist;

◦ Fixieren des Hologramms in der Photopolymerschicht B* durch flächige breitbandige UV/VIS-Belichtung des ganzen Schichtaufbaus A-B*-C mit einer Lichtenergie-Dosis von 5-10 J/cm$^2$; sodass der Schichtverbund A-B'-C entsteht, wobei B' die geblichene, durchpolymerisierte und nicht mehr photoempfindliche Photopolymerschicht B mit einem fixiertem Hologramm ist.

- Herstellen einer holographischen Folie mit dem Schichtaufbau A-B'-C-D-E, umfassend:

◦ Aufbringen der Klebstoffschicht D auf die Schutzschicht C des Schichtaufbaus AB'-C, sodass der Schichtverbund A-B'-C-D entsteht, vorzugsweise durch Auflaminieren des Beschichtungsmittels, wobei die Klebstoffschicht D vorzugsweise ein OCA-Klebefolie (optical clear adhesive-Klebefolie) ist;

◦ ggf. entfernen der Kaschierfolie der OCA-Klebstoffschicht;

◦ Aufbringen der Substratschicht E auf den Schichtaufbaus A-B'-C-D, sodass der Schichtverbund A-B'-C-D-E entsteht, wobei die Substratschicht E vorzugsweise Glas ist und auflaminiert wird;

◦ ggf. flächige breitbandige UV/VIS-Belichtung des ganzen Folienaufbaus A-B'-CD-E mit einer Lichtenergie-Dosis von 5-10 J/cm$^2$.

Die letzte optionale UV/VIS-Belichtung des ganzen Folienaufbaus A-B'-C-D-E hat den Vorteil, dass dabei ein UV härtender Optical Clear Adhesive als Klebstoffschicht D, wie z.B. OCA-69604 der Fa. Tesa SE, Norderstedt, Deutschland, aushärtet und endgültig fixiert wird.

In einer weiteren bevorzugten Ausführung des erfindungsgemäßen Verfahrens umfasst dieses die folgenden Schritte:

- Herstellen einer lichtempfindlichen holographischen Folie mit dem Schichtaufbau A-B-C, umfassend:

◦ Vorbereitung eines Beschichtungsmittel für die Herstellung der Photopolymerschicht B;

◦ Beschichtung des Substrates A mit diesem Beschichtungsmittel, sodass der Schichtverbund A-B entsteht;

◦ Vorbereitung eines wässrigen Beschichtungsmittel für die Herstellung der Schutzschicht C umfassend

(I) mindestens einen Polyvinylalkohol,

(II) mindestens einen Vernetzer für Polyvinylalkohole,

(III) gegebenenfalls mindestens einen Haftvermittler, wobei der Haftvermittler vorzugsweise mindestens ein Hydrolysat eines Aminoalkyl-trialkoxyilans ist, und

(IV) gegebenenfalls mindestens ein Tensid

◦ Beschichtung der Photopolymerschicht B des Schichtaufbaus A-B mit diesem Beschichtungsmittel, sodass der Schichtverbund A-B-C entsteht;

◦ Trocknen des Schichtverbundes A-B-C;

◦ Vorbereitung eines Beschichtungsmittel für die Herstellung der Klebstoffschicht D, wobei das Beschichtungsmittel vorzugsweise ein OCA-Klebefolie (optical clear adhesive-Klebefolie) ist;

◦ Aufbringen der Klebstoffschicht D auf die Schutzschicht C des Schichtaufbaus AB-C im Dunkeln, sodass der Schichtverbund A-B-C-D entsteht, vorzugsweise durch Auflaminieren des Beschichtungsmittels im Dunkeln;

◦ ggf. entfernen der Kaschierfolie der OCA-Klebstoffschicht im Dunkeln;

◦ Aufbringen der Substratschicht E auf den Schichtaufbaus A-B-C-D im Dunkeln, vorzugsweise durch Auflaminieren, sodass der lichtempfindliche Schichtverbund A-B-C-D-E entsteht, wobei die Substratschicht E, vorzugsweise Glas ist.

- Herstellen einer holographischen Folie mit dem Schichtaufbau A-B'-C-D-E, umfassend:

◦ Einschreiben eines Hologramms in die Photopolymerschicht B des Schichtverbundes A-B-C-D-E, sodass der Schichtverbund A-B*-C-D-E entsteht, wobei B* eine Photopolymerschicht mit einem eingeschriebenen Hologramm ist;

◦ Fixieren des Hologramms in der Photopolymerschicht B* durch flächige breitbandige UV/VIS-Belichtung des ganzen Schichtaufbaus A-B*-C mit einer Lichtenergie-Dosis von 5-10 J/cm$^2$; sodass der Schichtverbund A-B'-C-D-E entsteht, wobei B' die geblichene, durchpolymerisierte und nicht mehr photoempfindliche Photopolymerschicht B mit einem fixiertem Hologramm ist.

In einer bevorzugten Ausführungsform des erfindungsgemäßen Verfahrens weist der mindestens eine Polyvinylalkohol nach DIN 53015:2001-02 als 4 Gew.-%ige Lösung in Wasser bei 20° C eine Viskosität von $\geq$ 25 mPa*s, vorzugsweise $\geq$ 50 mPa*s auf.
In einer bevorzugten Ausführungsform des erfindungsgemäßen Verfahrens weist der Polyvinylalkohol nach DIN EN ISO 3681:2007-10-01 einen Hydrolysegrad von $\geq$ 85 mol-%, bevorzugter $\geq$ 95 mol-% auf.
In einer bevorzugten Ausführungsform des erfindungsgemäßen Verfahrens ist der Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon.
In einer bevorzugten Ausführungsform des erfindungsgemäßen Verfahrens beträgt das Gewichtsverhältnis der jeweils eingesetzten Gesamtmenge von dem mindestens einen Polyvinylalkohol zu dem mindestens einen Vernetzer von 70:30 bis 90:10, bevorzugter von 75:25 bis 80:20, noch bevorzugter von 75:25 bis 82:18.
In einer bevorzugten Ausführungsform des erfindungsgemäßen Verfahrens weist die gehärtete Schutzschicht C eine Schichtdicke von 3 $\mu$m bis 30 $\mu$m, bevorzugt 5 $\mu$m bis 15 $\mu$m auf.
Ebenfalls Gegenstand der Erfindung ist ein Schichtaufbau erhältlich aus dem erfindungsgemäßen Verfahren.

<u>Substratschicht A</u>

Die Substratschicht A ist vorzugsweise eine thermoplastische Substratschicht/Substratfolie oder ein anderer Träger wie z.B. Glas, Kunststoff, Metall oder Holz. Materialien oder Materialverbünde der thermoplastischen Substratschicht A basieren auf Polycarbonat (PC), Polyethylenterephthalat (PET), amorphem Polyester, Polybutylenterephthalat, Polyethylen, Polypropylen, Celluloseacetat, Cellulosehydrat, Cellulosenitrat, Cycloolefinpolymere, Polystyrol, hydriertem Polystyrol, Polyepoxide, Polysulfon, thermoplastisches Polyurethan (TPU), Cellulosetriacetat (CTA), Polyamid (PA), Polymethylmethacrylat (PMMA), Polyvinylchlorid, Polyvinylacetat, Polyvinylbutyral oder Polydicyclopentadien oder deren Mischungen. Besonders bevorzugt basieren sie auf PC, PET, PA, PMMA und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PMMA, PC/PA, PC/PET, PET/PC/PET und

PC/TPU. Vorzugsweise ist Substratschicht A im spektralen Bereich von 400-800 nm transparent.

Photopolymerschicht B

In die unbelichtete Photopolymerschicht B kann ein Hologramms eingeschrieben werden, gefolgt von optischem Fixieren des Hologramms vorzugsweise durch flächige breitbandige UV/VIS-Belichtung der Photopolymerschicht mit dem eingeschriebenen Hologramm mit einer Lichtenergie-Dosis von 5-10 J/cm$^2$. Bei dem Fixieren werden Reste von Schreibmonomeren, die bei der lokalen Entstehung des Hologramms nicht involviert waren, in der ganzen Photopolymerschicht durchpolymerisiert. Die als Sensibilisatoren dienenden Farbstoffe werden ebenfalls photochemisch zerstört. Die durch Farbstoffe verursachte starke technologische Verfärbung der Photopolymerschicht B verschwindet gänzlich. Die Photopolymerschicht B wird durch die Fixierung geblichen und verwandelt sich in eine nicht mehr photoaktive, farbstofffreie, stabile Photopolymerschicht B mit einem eingeschriebenen Hologramm.

In der Photopolymerschicht können ein oder mehrere Hologramme an derselben Stelle oder nebeneinander einbelichtet werden/sein. Belichtet man an derselben Stelle ein, so können unterschiedliche Bildinhalte einbelichtet werden. Ebenfalls können auch verschiedene Ansichten eines Objektes mit leicht variierenden Rekonstruktionswinkeln einbelichtet werden, so dass Stereogramme entstehen. Ebenfalls ist es möglich versteckte Hologramme und Mikrotexte einzubelichten. Gleichermaßen ist es im Falle von Transmissionshologrammen möglich, mehrere lichtleitende Funktionen und / oder lichtleitende Funktionen für verschiedene spektrale Bereiche einzubelichten.

Vorzugsweise weist die Photopolymerschicht B vernetzte Matrixpolymere auf, insbesondere dreidimensional vernetzte Matrixpolymere, wobei die Matrixpolymere vorzugsweise Polyurethane sind.

Die Photopolymerschicht B umfasst Matrixpolymere, Schreibmonomere und Photoinitiatoren. Als Matrixpolymere können amorphe Thermoplaste wie z.B. Polyacrylate, Polymethylmethacrylate oder Copolymere von Methylmethacrylat, Methacrylsäure oder andere Alkylacrylate und Alkylmethacrylate sowie Acrylsäure, wie z.B. Polybutylacrylat, weiterhin Polyvinylacetat und Polyvinylburyrat, seine partiell hydrolysierten Derivate wie Polyvinylalkohole sowie Copolymerisate mit Ethylen und / oder weiteren (Meth)acrylaten, Gelatine, Celluloseester und Celluloseether wie Methylcellulose, Celluloseacetobutyrat, Silikone, wie z.B. Polydimethylsilicon, Polyurethane, Polybutadiene und Polyisoprene, sowie Polyethylenoxide,Epoxyharze, insbesondere aliphatische Epoxyharze, Polyamide, Polycarbonate sowie die in US 4994347A und darin zitierten Systeme verwendet werden.

Epoxyharze können kationisch mit sich selbst vernetzt werden. Weiterhin können auch Säure/anhydride, Amine, Hydoxyalkylamide sowie Thiole als Vernetzer eingesetzt werden. Silicone können sowohl als Einkomponentensysteme durch Kondensation bei Anwesenheit von Wasser (und ggf. unter Broenstedtsäurenkatalyse) oder als zweikomponentige Systeme durch Zugabe von Kieselsäureester oder zinnorganische Verbindungen vernetzt werden. Ebenso ist die Hydrosilylierungen in Vinyl-Silansystemen möglich.

Ungesättigte Verbindungen, wie z.B. Acryloyl funktionelle Polymere oder ungesättigte Ester können mit Aminen oder Thiolen vernetzt werden. Eine kationische Vinyletherpolymerisation ist auch möglich.

Insbesondere bevorzugt ist aber, wenn die Matrixpolymere vernetzt, bevorzugt dreidimensional vernetzt und ganz besonders bevorzugt dreidimensional vernetzte Polyurethane sind.

Polyurethan-Matrixpolymere sind insbesondere durch Umsetzung wenigstens einer Polyisocyanat-Komponente a) mit wenigstens einer Isocyanat-reaktiven-Komponente b) erhältlich.

Die Polyisocyanat-Komponente a) umfasst wenigstens eine organische Verbindung mit wenigstens zwei NCO-Gruppen. Bei diesen organischen Verbindungen kann es sich insbesondere um monomere Di- und Triisocyanate, Polyisocyanate und / oder NCO-funktionelle Prepolymere handeln. Die Polyisocyanat-Komponente a) kann auch Mischungen monomerer Di- und Triisocyanate, Polyisocyanate und / oder NCO-funktioneller Prepolymere enthalten oder daraus bestehen.

Als monomere Di- und Triisocyanate können alle dem Fachmann an sich gut bekannten Verbindungen oder deren Mischungen eingesetzt werden. Diese Verbindungen können aromatische, araliphatische, aliphatische oder cycloaliphatische Strukturen aufweisen. In untergeordneten Mengen können die monomeren Di- und Triisocyanate auch Monoisocyanate, d.h. organische Verbindungen mit einer NCO-Gruppe umfassen.

Beispiele für geeignete monomere Di- und Triisocyanate sind 1,4-Butandiisocyanat, 1,5-Pentandiisocyanat, 1,6-Hexandiisocyanat (Hexamethylendiisocyanat, HDI), 2,2,4-Trimethylhexamethylendiisocyanat und / oder 2,4,4-Trimethylhexamethylendiisocyanat (TMDI), Isophorondiisocyanat (IPDI), 1,8-Diisocyanato-4-(isocyanatomethyl)-octan, Bis-(4,4'-isocyanatocyclohexyl)-methan und / oder Bis-(2,4isocyanatocyclohexyl)methan und /oder deren Mischungen beliebigen Isomerengehalts, 1,4-Cyclohexandiisocyanat, die isomeren Bis-(isocyanatomethyl)cyclohexane, 2,4- und / oder 2,6-Diisocyanato-l-methylcyclohexan, (Hexahydro-2,4- und / oder 2,6-toluylendiisocyanat, H6-TDI), 1,4-Phenylendiisocyanat, 2,4- und / oder 2,6-Toluylendiisocyanat (TDI), 1,5-Naphthylendiisocyanat (NDI), 2,4'-und / oder 4,4'-Diphenylmethandiisocyanat (MDI), 1,3-Bis(isocyanatomethyl)benzol (XDI) und / oder das analoge 1,4-Isomere oder beliebige Mischungen der vorgenannten Verbindungen.

Geeignete Polyisocyanate sind Verbindungen mit Urethan-, Harnstoff-, Carbodiimid-, Acylharnstoff-, Amid-,

Isocyanurat-, Allophanat-, Biuret-, Oxadiazintrion-, Uretdion- und / oder Iminooxadiazindionstrukturen, die aus den vorgenannten Di- oder Triisocyanaten erhältlich sind.

Besonders bevorzugt handelt es sich bei den Polyisocyanaten um oligomerisierte aliphatische und / oder cycloaliphatische Di- oder Triisocyanate, wobei insbesondere die oben stehenden aliphatischen und / oder cycloaliphatischen Di- oder Triisocyanate verwendet werden können.

Ganz besonders bevorzugt sind Polyisocyanate mit Isocyanurat-, Uretdion- und / oder Iminooxadiazindion-Strukturen sowie Biurete basierend auf HDI oder deren Mischungen.

Geeignete Prepolymere enthalten Urethan- und / oder Harnstoff-Gruppen sowie gegebenenfalls weitere durch Modifizierung von NCO-Gruppen entstandene Strukturen wie oben genannt. Derartige Prepolymere sind beispielsweise durch Umsetzung der oben genannten monomeren Di- und Triisocyanate und / oder Polyisocyanaten al) mit isocyanatreaktiven Verbindungen b1) erhältlich. Als isocyanatreaktive Verbindungen b1) können Alkohole, Amino oder Mercapto-Verbindungen, bevorzugt Alkohole, verwendet werden. Dabei kann es sich insbesondere um Polyole handeln. Ganz besonders bevorzugt können als isocyanatreaktive Verbindung b1) Polyester-, Polyether-, Polycarbonat-, Poly(meth)acrylat- und / oder Polyurethan-Polyole verwendet werden.

Als Polyesterpolyole sind beispielsweise lineare Polyesterdiole oder verzweigte Polyesterpolyole geeignet, die in bekannter Weise durch Umsetzung von aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden können. Beispiele für geeignete Di- bzw. Polycarbonsäuren sind mehrwertige Carbonsäuren wie Bernstein-, Adipin-, Kork-, Sebacin-, Decandicarbon-, Phthal-, Terephthal-, Isophthal- Tetrahydrophthal- oder Trimellithsäure sowie Säureanhydride wie Phthal-, Trimellith- oder Bernsteinsäureanhydrid oder deren beliebige Gemische untereinander. Die Polyesterpolyole können auch auf natürlichen Rohstoffen wie Rizinusöl basieren. Es ist ebenfalls möglich, dass die Polyesterpolyole auf Homo- oder Mischpolymerisaten von Lactonen basieren, die bevorzugt durch Anlagerung von Lactonen bzw. Lactongemischen wie Butyrolacton, ε-Caprolacton und / oder Methyl-ε-caprolacton an hydroxyfunktionelle Verbindungen wie mehrwertige Alkohole einer OH-Funktionalität $\geq 2$ beispielsweise der nachstehend genannten Art erhalten werden können.

Beispiele für geeignete Alkohole sind alle mehrwertigen Alkohole wie z.B. die $C_2$ - $C_{12}$-Diole, die isomeren Cyclohexandiole, Glycerin oder deren beliebige Gemische untereinander.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkohole einer OH-Funktionalität $\geq 2$, bevorzugt Butandiol-1,4, Hexandiol-1,6 und / oder 3-Methylpentandiol. Auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin sowie ihre beliebigen Mischungen.

Als Starter können die an sich im Rahmen der Polyesterpolyole genannten mehrwertigen Alkohole einer OH-Funktionalität $\geq 2$ sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden. Besonders bevorzugt sind Propylenoxid-homopolymere sowie statistische oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten $C_3$- und $C_4$-Isomere.

Daneben sind als Bestandteile der Polyol-Komponente b1) als polyfunktionelle, isocyanatreaktive Verbindungen auch niedermolekulare, d.h. mit Molekulargewichten $\leq 500$ g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise in Ergänzung zu den oben genannten Verbindungen Neopentylglykol, 2-Ethyl-2-butylpropandiol, Trimethylpentandiol, stellungs-isomere Diethyloctandiole, Cyclohexandiol, 1,4-Cyclohexandimethanol, 1,6-Hexandiol, 1,2- und 1,4-Cyclohexandiol, hydriertes Bisphenol A, 2,2-Bis(4-hydroxy-cyclohexyl)-propan oder 2,2-Dimethyl-3-hydroxypropionsäure, 2,2-dimethyl-3-hydroxypropyl-ester sein. Beispiele geeigneter Triole sind Trimethylolethan, Trimethylolpropan oder Glycerin. Geeignete höherfunktionelle Alkohole sind Di-(trimethylolpropan), Pentaerythrit, Dipenta-erythrit oder Sorbit.

Besonders bevorzugt ist, wenn die Polyolkomponente ein difunktioneller Polyether-, Polyester oder ein Polyether-polyester-block-copolyester oder ein Polyether-Polyester-Blockcopolymer mit primären OH-Funktionen ist.

Es ist ebenfalls möglich, als isocyanatreaktive Verbindungen b1) Amine einzusetzen. Beispiele geeigneter Amine sind Ethylendiamin, Propylendiamin, Diaminocyclohexan, 4,4'-Dicylohexylmethandiamin, Isophorondiamin (IPDA), difunktionelle Polyamine wie z.B. die Jeffamine®, aminterminierte Polymere, insbesondere mit zahlenmittleren Molmassen ≤ 10.000 g/Mol. Mischungen der vorgenannten Amine können ebenfalls verwendet werden.

Es ist ebenfalls möglich, als isocyanatreaktive Verbindungen b1) Aminoalkohole einzusetzen. Beispiele geeigneter Aminoalkohole sind die isomeren Aminoethanole, die isomeren Aminopropanole, die isomeren Aminobutanole und die isomeren Aminohexanole oder deren beliebige Mischungen.

Alle vorgenannten isocyanatreaktiven Verbindungen b1) können untereinander beliebig vermischt werden.

Bevorzugt ist auch, wenn die isocyanatreaktiven Verbindungen b1) eine zahlenmittlere Molmasse von ≥ 200 und ≤ 10.000 g/Mol, weiter bevorzugt ≥ 500 und ≤ 8.000 g/Mol und ganz besonders bevorzugt ≥ 800 und ≤ 5.000 g/Mol aufweisen. Die OH-Funktionalität der Polyole beträgt bevorzugt 1.5 bis 6.0, besonders bevorzugt 1.8 bis 4.0.

Die Prepolymere der Polyisocyanat-Komponente a) können insbesondere einen Restgehalt an freiem monomeren Di- und Triisocyanaten < 1 Gew.-%, besonders bevorzugt < 0.5 Gew.-% und ganz besonders bevorzugt < 0.3 Gew.-% aufweisen.

Es ist gegebenenfalls auch möglich, dass die Polyisocyanat-Komponente a) vollständig oder anteilsmäßig organische Verbindung enthält, deren NCO-Gruppen ganz oder teilweise mit aus der Beschichtungstechnologie bekannten Blockierungsmitteln umgesetzt sind. Beispiel für Blockierungsmittel sind Alkohole, Lactame, Oxime, Malonester, Pyrazole sowie Amine, wie z.B. Butanonoxim, Diisopropylamin, Malonsäurediethylester, Acetessigester, 3,5-Dimethylpyrazol, ε-Caprolactam, oder deren Mischungen.

Besonders bevorzugt ist, wenn die Polyisocyanat-Komponente a) Verbindungen mit aliphatisch gebundenen NCO-Gruppen umfasst, wobei unter aliphatisch gebundenen NCO-Gruppen derartige Gruppen verstanden werden, die an ein primäres C-Atom gebunden sind. Die isocyanatreaktive Komponente b) umfasst bevorzugt wenigstens eine organische Verbindung, die im Mittel wenigstens 1.5 und bevorzugt 2 bis 3 isocyanatreaktive Gruppen aufweist. Im Rahmen der vorliegenden Erfindung werden als isocyanatreaktive Gruppen bevorzugt Hydroxy-, Amino- oder MercaptoGruppen angesehen.

Die isocyanatreaktive Komponente kann insbesondere Verbindungen umfassen, die im Zahlenmittel wenigstens 1.5 und bevorzugt 2 bis 3 isocyanatreaktive Gruppen aufweisen.

Geeignete polyfunktionelle, isocyanatreaktive Verbindungen der Komponente b) sind beispielsweise die oben beschriebenen Verbindungen b1).

Erfindungsgemäß geeignete Photoinitiatoren sind üblicherweise durch aktinische Strahlung aktivierbare Verbindungen, die eine Polymerisation der Schreibmonomere auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation unterschieden.

Typ I-Photoinitiatoren (Norrish-Typ-I) für die radikalische Photopolymerisation bilden beim Bestrahlen durch eine unimolekulare Bindungsspaltung freie Radikale. Beispiele für Typ I-Photoinitiatoren sind Triazine, Oxime, Benzoinether, Benzilketale, Bis-imidazole, Aroylphosphinoxide, Sulfonium- und Iodoniumsalze.

Typ II-Photoinitiatoren (Norrish-Typ-II) für die radikalische Polymerisation bestehen aus einem Farbstoff als Sensibilisator und einem Coinitiator und durchlaufen bei der Bestrahlung mit auf den

Farbstoff angepasstem Licht eine bimolekulare Reaktion. Zunächst absorbiert der Farbstoff ein Photon und überträgt aus einem angeregten Zustand Energie auf den Coinitiator. Dieser setzt durch Elektronen- oder Protonentransfer oder direkte Wasserstoffabstraktion die polymerisationsauslösenden Radikale frei.

Im Sinne dieser Erfindung werden bevorzugt Typ II-Photoinitiatoren verwendet.

Farbstoff und Coinitiator der Typ II-Photoinitiatoren können entweder unmittelbar gemeinsam mit den weiteren Komponenten des Photopolymers vermischt werden oder aber auch jeweils mit Einzelkomponenten vorvermischt werden. Insbesondere wenn das Photopolymer Polyurethan-Matrixpolymere enthalten soll, kann der Farbstoff mit der Isocyanat-reaktiven Komponente und der Coinitiator mit der Isocyanat-Komponente vorvermischt werden. Ebenso ist es aber auch möglich den Coinitiator mit der Isocyanat-reaktiven Komponente und den Farbstoff mit der Isocyanat-Komponente vorher zu vermischen.

Solche Photoinitiatorsysteme sind prinzipiell in der EP 0 223 587 A beschrieben und bestehen bevorzugt aus einer Mischung von einem oder mehreren Farbstoffen mit Ammoniumalkylarylborat(en).

Geeignete Farbstoffe, die zusammen mit einem Ammoniumalkylarylborat einen Typ II-Photoinitiator bilden, sind die in der WO 2012062655 beschriebenen kationischen Farbstoffe in Kombination mit den eben dort beschriebenen Anionen.

Geeignete Ammoniumalkylarylborate sind beispielsweise (Cunningham et al., RadTech'98 North America UV/EB Conference Proceedings, Chicago, Apr. 19-22, 1998): Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat hexylborat ([191726-69-9], CGI 7460, Produkt der BASF SE, Basel, Schweiz), 1-Methyl-3-octylimidazolium Dipentyldiphenylborat und Tetrabutylammonium Tris-(3-chlor-4-methylphenyl)-hexylborat ([1147315-11-4], CGI 909, Produkt der BASF SE, Basel, Schweiz).

Es kann vorteilhaft sein, Gemische dieser Photoinitiatoren einzusetzen. Je nach verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in der Photopolymer-Formulierung enthalten ist.

Weiter bevorzugt ist auch, wenn die Photopolymer-Formulierung für wenigstens zwei Laserlichtfarben ausgewählt aus blau, grün und rot je einen geeigneten Photoinitiator enthält.

Ganz besonders bevorzugt ist schließlich, wenn die Photopolymer-Formulierung für jede der Laserlichtfarben blau, grün und rot jeweils einen geeigneten Photoinitiator enthält.

Bei einer weiteren bevorzugten Ausführungsform ist vorgesehen, dass die Schreibmonomere ein mono- und / oder ein multifunktionelles (Meth)acrylat-Schreibmonomere umfassen. Ganz besonders bevorzugt können die Schreibmonomere zusätzlich wenigstens ein mono- und / oder ein multifunktionelles Urethan(meth)acrylat umfassen.

Geeignete Acrylat-Schreibmonomere sind insbesondere Verbindungen der allgemeinen Formel (I)

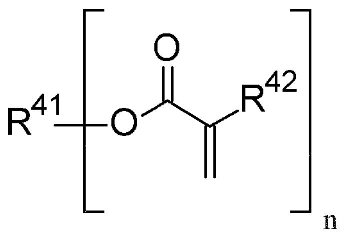

(I)

bei denen n≥1 und n≤4 ist und $R^{41}$ ein linearer, verzweigter, cyclischer oder heterocyclischer unsubstituierter oder gegebenenfalls auch mit Heteroatomen substituierter organischer Rest und / oder $R^{42}$ Wasserstoff, ein linearer, verzweigter, cyclischer oder heterocyclischer unsubstituierter oder gegebenenfalls auch mit Heteroatomen substituierter organischer Rest ist. Besonders bevorzugt ist $R^{42}$ Wasserstoff oder Methyl und / oder $R^{41}$ ein linearer, verzweigter, cyclischer oder heterocyclischer unsubstituierter oder gegebenenfalls auch mit Heteroatomen substituierter organischer Rest.

Als Acrylate bzw. Methacrylate werden vorliegend Ester der Acrylsäure bzw. Methacrylsäure bezeichnet. Beispiele bevorzugt verwendbarer Acrylate und Methacrylate sind Phenylacrylat, Phenylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Bisphenol A Diacrylat, Bisphenol A Dimethacrylat, sowie deren ethoxylierte Analogverbindungen, N-Carbazolylacrylate.

Als Urethanacrylate werden vorliegend Verbindungen mit mindestens einer Acrylsäureestergruppe und mindestens eine Urethanbindung verstanden. Solche Verbindungen können beispielsweise durch Umsetzung eines Hydroxy-funktionellen Acrylats oder Methacrylats mit einer Isocyanatfunktionellen Verbindung erhalten werden.

Beispiele hierfür verwendbarer Isocyanat-funktionelle Verbindungen sind Monoisocyanate sowie die unter a) genannten monomeren Diisocyanate, Triisocyanate und / oder Polyisocyanate. Beispiele geeigneter Monoisocyanate sind Phenylisocyanat, die isomeren Methylthiophenylisocyanate. Di-, Tri- oder Polyisocyanate sind oben genannt sowie Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise Verbindungen wie 2-Hydroxyethyl(meth)acrylat, Polyethylenoxid-mono-(meth)acrylate, Polypropylenoxidmono(meth)acrylate, Polyalkylenoxidmono(meth)-acrylate, Poly-(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3 -Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono-(meth)acrylat.

Ebenfalls verwendet werden können die an sich bekannten hydroxylgruppenhaltigen Epoxy(meth)-acrylate mit

OH-Gehalten von 20 bis 300 mg KOH/g oder hydroxylgruppenhaltige Polyurethan-(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und / oder m-Methylthiophenylisocyanat mit alkoholfunktionellen Acrylaten wie Hydroxyethyl(meth)acrylat, Hydroxypropyl(meth)acrylat und / oder Hydroxybutyl(meth)-acrylat.

Ebenso ist es möglich, dass das Schreibmonomer weitere ungesättigte Verbindungen wie $\alpha$,$\beta$-ungesättigte Carbonsäurederivate wie beispielsweise Maleinate, Fumarate, Maleimide, Acrylamide, weiterhin Vinylether, Propenylether, Allylether und Dicyclopentadienyl-Einheiten enthaltende Verbindungen sowie olefmisch ungesättigte Verbindungen wie z.B. Styrol, $\alpha$-Methylstyrol, Vinyltoluol und / oder Olefine, umfasst.

Gemäß einer weiteren bevorzugten Ausführungsform ist vorgesehen, dass die Photopolymer-Formulierung zusätzlich monomere Urethane als Additive enthält, wobei die Urethane insbesondere mit wenigstens einem Fluoratom substituiert sein können.

Bevorzugt können die Urethane die allgemeine Formel (II)

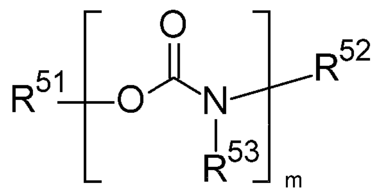

(II)

haben, in der m≥1 und m≤8 ist und $R^{51}$, $R^{52}$ und $R^{53}$ lineare, verzweigte, cyclische oder heterocyclische unsubstituierte oder gegebenenfalls auch mit Heteroatomen substituierte organische Reste und / oder $R^{52}$, $R^{53}$ unabhängig voneinander Wasserstoff sind, wobei bevorzugt mindestens einer der Reste $R^{51}$, $R^{52}$, $R^{53}$ mit wenigstens einem Fluoratom substituiert ist und besonders bevorzugt $R^{51}$ ein organischer Rest mit mindestens einem Fluoratom ist. Besonders bevorzugt ist $R^{52}$ ein linearer, verzweigter, cyclischer oder heterocyclischer unsubstituierter oder gegebenenfalls auch mit Heteroatomen wie beispielsweise Fluor substituierter organischer Rest.

Gemäß einer weiteren bevorzugten Ausführungsform der Erfindung ist vorgesehen, dass das Photopolymer 10 bis 89.999 Gew.-%, bevorzugt 20 bis 70 Gew.-% Matrixpolymere, 3 bis 60 Gew.-%, bevorzugt 10 bis 50 Gew.-% Schreibmonomere, 0.001 bis 5 Gew.-%, bevorzugt 0.5 bis 3 Gew.-% Photoinitiatoren und gegebenenfalls 0 bis 4 Gew.-%, bevorzugt 0 bis 2 Gew.-% Katalysatoren, 0 bis 5 Gew.-% , bevorzugt 0.001 bis 1 Gew.-% Stabilisatoren, 0 bis 40 Gew.-%, bevorzugt 10 bis 30 Gew.-% monomere Fluorurethane und 0 bis 5 Gew.-%, bevorzugt 0.1 bis 5 Gew.-% weitere Additive enthält, wobei die Summe aller Bestandteile 100 Gew.-% beträgt.

Besonders bevorzugt werden Photopolymer mit 20 bis 70 Gew.-% Matrixpolymeren, 20 bis 50 Gew.-% Schreibmonomere, 0.001 bis 5 Gew.-% Photoinitiatoren, 0 bis 2 Gew.-% Katalysatoren, 0.001 bis 1 Gew.-% Radikalstabilisatoren gegebenenfalls 10 bis 30 Gew.-% Fluorurethane und gegebenenfalls 0.1 bis 5 Gew.-% weiterer Additive eingesetzt.

Als Katalysatoren können Urethanisierungskatalysatoren, wie z.B. organische oder anorganischen Derivate des Bimuths, des Zinns, des Zinks oder des Eisens (siehe dazu auch die in der US 2012/062658 genannten Verbindungen) verwendet werden. Besonders bevorzugte Katalysatoren sind Butylzinn-tris(2-ethylhexanoat), Eisen(III) - trisacetylacetonat, Bismuth(III)tris(2-ethylhexanoat), und Zinn(II) bis(2-ethylhexanoat). Weiterhin können auch sterisch gehinderte Amine als Katalysatoren eingesetzt werden.

Als Stabilisatoren können Radikalinhibitoren wie HALS-Amine, N-Alkyl-HALS, N-Alkoxy-HALS- und N-Alkoxyethyl-HALS-Verbindungen sowie Antioxidantien und / oder UV Absorber zum Einsatz kommen.

Als weitere Additive können Verlaufshilfsmittel und / oder Antistatika und / oder Thixotropiermittel und / oder Verdicker und / oder Biozide eingesetzt werden.

<u>Schutzschicht C</u>

Die Schicht C ist eine Schutzschicht bzw. Barriereschicht, die den Durchtritt für die flüssigen organischen Komponenten des "OCA" unterbindet, da diese Schicht für die Klebstoffkomponenten nicht durchlässig ist. Hierdurch lässt sich ein negativer Einfluss der Klebstoffkomponenten auf das Hologramm verhindern. Des Weiteren wirkt diese Barriere-Schicht auch in Gegenrichtung, d.h. der Austritt und die mögliche Migration der Komponenten der Photopolymerschicht in die Klebstoffschicht wird ebenfalls unterbunden, was für die Gesamtstabilität des Hologramms entscheidend beiträgt.

Schicht C ist durch Umsetzung einer Zusammensetzung erhältlich, enthaltend mindestens einen Polyvinylalkohol, mindestens einen Vernetzer für Polyvinylalkohole, gegebenenfalls mindestens einen Haftvermittler, wobei der Haftvermittler vorzugsweise mindestens ein Hydrolysat eines Aminoalkyl-trialkoxyilans ist, gegebenenfalls mindestens ein Tensid und Wasser als einziges Lösungsmittel. Die Schutzschicht wird als wässrige Formulierung enthaltend die oben genannten Bestandteile auf die Photopolymerschicht B aufgetragen. Eine trockene Aufbringung durch Verwendung einer lösungsmittelfreien Formulierung ist ebenfalls möglich.

Als Polyvinylalkohole werden bevorzugt Polyvinylalkohole mit einem Hydrolysegrad mehr als 85 mol%, bevorzugter 95 mol% eingesetzt (gemessen nach DIN EN ISO 3681:2007-10-01. Besonders bevorzugt ist wenn die Polyvinylalkohole eine Viskosität ≥ 25 mPas, noch bevorzugter von ≥ 50 mPa*s (gemessen als 4%-ige wässrige Lösung bei 20 °C nach DIN 53015:2001-02) aufweisen.

Bevorzugte Polyvinylalkohole sind POVAL 60-98, POVAL 25-88KL und POVAL 25-98R von Kuraray Europe GmbH. Diese sind in heißem Wasser löslich und bilden dabei stabile, viskose Lösungen, aus denen transparente, zugfeste und elastische Beschichtungen hergestellt werden können, die auf mehreren Oberflächen sehr gut haften. Als vorteilhaft hat sich dabei erwiesen, dass solche Polyvinylalkohole in organischen Lösungsmitteln und sogar in kurzkettigen Alkoholen unlöslich sind, wodurch die mit ihnen erzeugten Filme und Beschichtungen eine besondere Beständigkeit gegen organische Lösungsmittel bekommen.

Als Vernetzer für die Polyvinylalkohole werden vorzugweise Substanzen verwendet ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon.

Glutaraldehyd, Oxalsäure, N,N'-Dimethylharnstoff, Magnesiumhydroxid, Calciumhydroxid, Borsäure, Borsäuresalze, Aluminate, Aluminiumsulfat, Kieselsäure, Kieselsäureester und / oder wässrige Glyoxal-Lösung, die mit bis 25-Gew.-% in den Festkörper der Schutzschicht C kommen, dienen als Vernetzer für Polyvinylalkohol, vernetzen bei dem Trocknen und bei der damit verbundenen thermischen Behandlung der Beschichtung und verbessern deren Stabilität auf Dauer. Erfindungsgemäß werden Vernetzer verwendet, deren Vernetzungsprozess rein thermisch läuft. Dies hat den Vorteil, dass die Photopolymerschicht bei der Herstellung der Folie sicher eingekapselt wird, ohne dabei ihre Photoempfindlichkeit zu beeinflussen.

Das Gewichtsverhältnis der jeweils eingesetzten Gesamtmenge von dem mindestens einen Polyvinylalkohol zu dem mindestens einen Vernetzer beträgt vorzugsweise von 70:30 bis 90:10, bevorzugter von 75:25 bis 80:20, noch bevorzugter von 75:25 bis 82:18.

Optional kann die Schutzschicht C mindestens einen Haftvermittler enthalten. Bevorzugte Haftvermittler im Sinne der Erfindung sind Hydrolysate von Aminoalkyl-trialkoxysilanen, wie beispielsweise Silquest VS 142 von Momentive. Vorzugsweise enthält die Schutzschicht die Haftvermittler mit bis zu 2 Gew.-% im Festkörper, bezogen auf das Gesamtgewicht des Festkörpers.

Optional kann die Schutzschicht C mindestens ein Tensid enthalten. Bevorzugt sind langkettige Alkohole, inbesondere $C_6$-$C_{18}$-Alkohole, bevorzugter $C_6$-$C_{14}$ Alkohole, noch bevorzugter $C_8$-$C_{12}$ Alkohole, wie beispielsweise 1-Octanol oder NOVEC-Fluorotenside von 3M. In einer besonders bevorzugten Aufführungsform wird 1-Octanol als Tensid verwendet.

Als Lösungsmittel für die Zusammensetzung bzw. Formulierung der ungehärteten Schutzschicht C wird Wasser verwendet. Die Verwendung von Wasser als Lösungsmittel hat den Vorteil, dass die Photopolymerschicht B in keiner Weise negativ beeinflusst wird und ermöglicht dadurch den Rolle-zu-Rolle-Prozess der Nassauftragung der Schutzschicht C auf den Schichtverbund A-B. Der Beschichtungsprozess wird bei unbelichteten und noch nicht fixierten Photopolymerschichten im Dunkeln durchgeführt. Die dadurch erhaltene Folie mit dem Schichtaufbau A-B-C behält ihre Photoempfindlichkeit und ermöglicht die Aufnahme von Hologrammen ohne weitere Beeinträchtigung.

Die erfindungsgemäße Schicht C beeinflusst in keiner Weise den Schreibprozess der Hologramme in einer Schicht B und reduziert deren Qualität nicht. Die Photoempfindlichkeit der A-B-C-Folie, wie die Intensität und auch die spektrale Lage des Hologramms unterscheiden sich kaum von den Werten für eine A-B-Folie ohne jegliche Schutzschicht bzw. Barriereschicht.

In einer bevorzugten Ausführungsform weist die gehärtete Schutzschicht C eine Schichtdicke von 3 μm bis 30 μm, bevorzugt 5 μm bis 15 μm auf.

Klebstoffschicht D

Als Klebstoffschicht D sind alle Klebstoffe geeignet, die nicht mit der Schutzschicht C und der Substratschicht E interferieren. Insbesondere werden als Klebstoffschicht optical clear adhesive-Klebstoffe verwendet (OCA-Klebstoffe). Bevorzugt werden OCA-Klebefolien als OCA-Klebstoffe verwendet, wie beispielsweise 8211 der Fa. 3M, die kein UV-Härten vorsieht und OCA-69604, ein UV härtender Optical Clear Adhesive der Fa. Tesa SE, Norderstedt, Deutschland. Im Falle von UV-härtbaren OCA-Klebstoffen kann die Härtung im Verlauf des erfindungsgemäßen Verfahrens vorgenommen werden, nachdem die Photopolymerschicht belichtet und optisch fixiert wurde. In einer weiteren Ausführungsform kann die optische Fixierung und die UV-Härtung des OCA-Klebstoffes in einem Verfahrensschritt durchgeführt werden, indem die Intensität der beaufschlagten UV-Strahlung entsprechend gewählt wird.

Substratschicht E

Die Substratschicht A kann eine thermoplastische Substratschicht/Substratfolie oder ein anderer Träger wie z.B. Glas, Kunststoff, Metall oder Holz. Materialien oder Materialverbünde der thermoplastischen Substratschicht E basierend auf Polycarbonat (PC), Polyethylenterephthalat (PET), amorphe Polyester, Polybutylenterephthalat, Polyethylen, Polypropylen, Celluloseacetat, Cellulosehydrat, Cellulosenitrat, Cycloolefinpolymere, Polystyrol, hydriertem Polystyrol, Polyepoxide, Polysulfon, thermoplastisches Polyurethan (TPU), Cellulosetriacetat (CTA), Polyamid (PA), Polymethylmethacrylat (PMMA), Polyvinylchlorid, Polyvinylacetat, Polyvinylbutyral oder Polydicyclopentadien oder deren Mischungen sein. Die Materialverbünde basieren bevorzugt auf PC, PET, PA, PMMA und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PMMA, PC/PA, PC/PET, PET/PC/PET und PC/TPU. Vorzugsweise ist Substratschicht E im spektralen Bereich von 400-800 nm transparent.

In einer bevorzugten Ausführungsform ist die Substratschicht E Glas.

Ebenfalls Gegenstand der Erfindung ist die Verwendung einer zumindest teilweise gehärteten Schutzschicht C zum Schutz einer Photopolymerschicht B, wobei die Schutzschicht C erhältlich ist durch Umsetzung einer wässrigen Zusammensetzung umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid.

In einer bevorzugten Ausführungsform der erfindungsgemäßen Verwendung weist der mindestens eine Polyvinylalkohol nach DIN 53015:2001-02 als 4 Gew.-%ige Lösung in Wasser bei 20° C eine Viskosität von ≥ 25 mPa*s, vorzugsweise ≥ 50 mPa*s auf.

In einer bevorzugten Ausführungsform der erfindungsgemäßen Verwendung weist der Polyvinylalkohol nach DIN EN ISO 3681:2007-10-01 einen Hydrolysegrad von ≥ 85 mol-%, bevorzugter ≥ 95 mol-% auf.

In einer bevorzugten Ausführungsform der erfindungsgemäßen Verwendung ist der Vernetzer für Polyvinylalkohole ausgewählt aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon.

Eine bevorzugte Ausführungsform ist die Verwendung einer zumindest teilweise gehärteten Schutzschicht C zum Schutz einer Photopolymerschicht B, wobei die Schutzschicht C erhältlich ist durch Umsetzung einer wässrigen Zusammensetzung umfassend

(I) mindestens einen Polyvinylalkohol der nach DIN 53015:2001-02 als 4 Gew.-%ige Lösung in Wasser bei 20° C eine Viskosität von ≥ 25 mPa*s, vorzugsweise ≥ 50 mPa*s aufweist,
(II) mindestens einen Vernetzer für Polyvinylalkohole ausgewählt ist aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon, vorzugsweise ausgewählt aus wässriger Glyoxal-Lösung, Borsäure, Borsäuresalzen und / oder Kombinationen aus mindestens zweien davon,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid.

Ebenfalls Gegenstand der Erfindung ist die Verwendung des erfindungsgemäßen Kit-of-parts zum Schutz einer Photopolymerschicht B, vorzugsweise enthaltend ein Volumenhologramm, bevorzugter wenn das Photopolymer B' dreidimensionale vernetzte Matrixpolymere, besonders bevorzugt eine dreidimensional vernetzte Polyurethan-Matrix umfasst.

Ebenfalls Gegenstand der Erfindung ist die Verwendung des erfindungsgemäßen Kit-of-parts oder des erfindungsgemäßen Schichtaufbaus für das erfindungsgemäße Verfahren.

Ebenfalls Gegenstand der Erfindung ist die Verwendung des erfindungsgemäßen Schichtaufbaus als holographisches Aufzeichnungsmedium.

Ebenfalls Gegenstand der Erfindung ist die Verwendung des erfindungsgemäßen Schichtaufbaus zur Herstellung von optischen Anzeigen und Sicherheitsdokumenten, wobei die optische Anzeige vorzugsweise ausgewählt ist aus der Gruppe bestehend aus autostereoskopischen und / oder holographischen Displays, Projektionsleinwänden, Projektionsscheiben, Displays mit schaltbaren eingeschränkten Abstrahlverhalten für Privacyfilter und bidirektionalen Multiuserbildschirmen, virtuellen Bildschirmen, Headup-Displays, Head-mounted Displays, Leuchtsymbole, Warnlampen, Signallampen, Scheinwerfer und Schautafeln.

In einer Ausführungsform enthält der erfindungsgemäße Schichtaufbau oder das erfindungsgemäße Kit-of-parts eine Hologramm enthaltende Photopolymerschicht mit einer Schichtdicke von 0.3 $\mu$m bis 500 $\mu$m, bevorzugt von 0.5 $\mu$m bis 200 $\mu$m und besonders bevorzugt von 1 $\mu$m bis 100 $\mu$m.

Insbesondere kann das Hologramm ein Reflektions-, Transmissions-, In-Line-, Off-Axis-, Full-Aperture Transfer-, Weißlicht-Transmissions-, Denisyuk-, Off-Axis Reflektions- oder Edge-Lit Hologramm sowie ein holographisches Stereogramm und bevorzugt ein Reflektions-, Transmissions- oder Edge-Lit Hologramm sein. Bevorzugt sind Reflektionshologramme, Denisyukhologramme, Transmissionshologramme.

Die Qualität des Hologramms wird durch folgende Kriterien nach ISO-Norm 17901-1:2015(E) definiert. In einer vereinfachten Form versteht man das Hologramm als ein optisches Gitter, dessen Periode im Idealfall von Wellenlänge des Schreiblasers ($\lambda_w$) bestimmt ist. Als diffraktives Element reflektiert dieses Gitter das Licht mit der Wellenlänge ($\lambda_w$). Aufgrund der hohen Effizienz des Hologramms lässt sich diese Reflektion mit einem spektral in Transmission analysieren und erscheint im Spektrum als Peak (bei $\lambda_{peak}$) mit reduzierter Transmission. Diese Reduzierung der Transmission

$$T_{Red} = (100\% - T_{peak(\text{erfindungsgemäßer Schichtaufbau, z. B. A-B'-C-D-E})}\%) \qquad (2)$$

dient als Maß für die Reflektionskraft (sichtbare "Stärke" oder "Qualität") des Hologramms.

Im Sinne der Erfindung ist die "Stärke" des Hologramms, die man im erfindungsgemäßen Schichtaufbau B-C, A-B-C, B-C-D, A-B-C-D, B-C-D-E oder A-B-C-D-E einschreiben kann, gar nicht oder nicht wesentlich schlechter, als dies im Aufbau A-B ohne jeglichen Schutzschichten der Fall ist. Diese Differenz $\Delta T$ lässt sich nach Formel (3) errechnen:

$$\Delta T = (100\% - T_{peak(\text{erfindungsgemäßer Schichtaufbau, z. B. A-B'-C-D-E})}\%) - (100\% - T_{peak(A\text{-}B')}\%) \quad (3)$$

Es ist bevorzugt, dass diese Differenz $\Delta T < 20$ %, besonders bevorzugt < 15 % und insbesondere bevorzugt < 10 % ist.

Die spektrale Verschiebung des Transmissionsspektrums ist definiert als Differenz ($\Delta\lambda$) aus der Wellenlänge des einschreibenden Lasers ($\lambda_w$) und dem spektralen Peak des eingeschriebenen Hologramm($\lambda_{peak}$) (ISO-Norm 17901-1:2015(E)):

$$\Delta\lambda = \lambda_{peak} - \lambda_w \qquad (1)$$

Vorzugsweise beträgt $\Delta\lambda$ des eingeschriebenen Hologramms im erfindungsgemäßen Schichtaufbau A-B'-C' +/- 10 nm, bevorzugter +/-5 nm, besonders bevorzugt +/-3 nm.

In der Photopolymerschicht können ein oder mehrere Hologramme an derselben Stelle oder nebeneinander einbelichtet werden/sein. Belichtet man an derselben Stelle ein, so können unterschiedliche Bildinhalte einbelichtet werden. Ebenfalls können auch verschiedene Ansichten eines Objektes mit leicht variierenden Rekonstruktionswinkeln einbelichtet werden, so dass Stereogramme entstehen. Ebenfalls ist es möglich versteckte Hologramme und Mikrotexte einzubelichten. Gleichermaßen ist es im Falle von Transmissionshologrammen möglich mehrere lichtleitende Funktionen und / oder lichtleitende Funktionen für verschiedene spektrale Bereiche einzubelichten.

Mögliche optische Funktionen der Hologramme entsprechen den optischen Funktionen von Lichtelementen wie Linsen, Spiegel, Umlenkspiegel, Filter, Streuscheiben, gerichteten Streuelemente, Beugungselemente, Lichtleiter, Lichtlenker (waveguides), Projektionsscheiben und / oder Masken. Zudem können mehrere derartiger optischer Funktionen in einem solchen Hologramm kombiniert werden, z.B. so dass je nach Lichteinfall das Licht in eine andere Richtung abgebeugt wird. So kann man beispielsweise mit derartigen Aufbauten autostereoskopische oder holographische elektronische Displays bauen, die es erlauben einen stereoskopischen visuellen Eindruck ohne weitere Hilfsmittel wie z.B. einer Polarisator- oder Shutterbrille zu erleben, der Verwendung in automobilen Head-up Displays oder Head-mounted Displays.

Häufig zeigen diese optischen Elemente eine spezifische Frequenzselektivität, je nachdem wie die Hologramme

belichtet wurden und welche Dimensionen das Hologramm hat. Dies ist insbesondere wichtig, wenn man monochromatische Lichtquellen wie LED oder Laserlicht verwendet. So benötigt man ein Hologramm pro Komplementärfarbe (RGB), um Licht frequenzselektiv zu lenken und gleichzeitig vollfarbige Displays zu ermöglichen. Daher sind in bestimmten Displayaufbauten mehrere Hologramme ineinander im Medium zu belichten.

Zudem können mittels des erfindungsgemäßen Schichtaufbaus auch holographische Bilder oder Darstellungen, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten hergestellt werden. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendungen dar. Auch ist es möglich derartige Hologramme zur Speicherung digitaler Daten zu verwenden, wobei verschiedenste Belichtungsverfahren (Shift-, Spatial- oder Angular- Multiplexing) verwendet werden.

Ebenfalls Gegenstand der Erfindung ist eine optische Anzeige, umfassend einen erfindungsgemäßen Schichtaufbau.

Beispiele für derartige optische Anzeigen sind bildgebende Anzeigen auf Basis von Flüssigkristallen, organischen lichtemittierenden Dioden (OLED), LED-Displaytafeln, Microelektromechanische Systeme (MEMS) auf Basis von diffraktiver Lichtselektion, Electrowettingdisplays (E-ink) und Plasmabildschirmen. Derartige optische Anzeigen können autostereoskopische und / oder holographische Displays, transmittive und reflektive Projektionsleinwände oder Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln sein.

Ebenfalls Gegenstand der Erfindung sind autostereoskopische und / oder holographische Displays, Projektionsleinwände, Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln umfassend einen erfindungsgemäßen Schichtaufbau enthaltend ein Hologramm.

Noch weitere Gegenstände der Erfindung sind ein Sicherheitsdokument und ein holographisch optisches Element umfassend einen erfindungsgemäßen Schichtaufbau.

Darüber hinaus ist auch die Verwendung eines erfindungsgemäßen Schichtaufbaus zur Herstellung von Chipkarten, Ausweisdokumenten, 3D-Bildern, Produktschutzetiketten, Labeln, Banknoten oder holographisch optischen Elementen insbesondere für optische Anzeigen Gegenstand der Erfindung.

## Beispiele

Die Erfindung wird im Folgenden anhand von Beispielen näher erläutert.

## Messmethoden:

| | |
|---|---|
| Festkörpersehalt: | Die angegebenen Festkörpergehalte wurden gemäß DIN EN ISO 3251 bestimmt. |

## Chemikalien:

In eckigen Klammem ist jeweils, soweit bekannt, die CAS-Nummer angegeben.

### Rohstoffe der Photopolymerschicht B

| | |
|---|---|
| Fomrez® UL 28 | Urethanisierungskatalysator, Handelsprodukt der Momentive Performance Chemicals, Wilton, CT, USA. |
| Borchi® Kat 22 | Urethanisierungskatalysator, [85203-81-2] Handelsprodukt der OMG Borchers GmbH, Langenfeld, Deutschland. |

(fortgesetzt)

| | |
|---|---|
| BYK-310 | Silikonhaltiges Oberflächenadditiv, Produkt der BYK-Chemie GmbH, Wesel, Deutschland. |
| Desmodur® N 3900 | Produkt der Covestro AG, Leverkusen, DE, Hexandiisocyanatbasiertes Polyisocyanat, Anteil an Iminooxadiazindion mindestens 30 %, NCO-Gehalt: 23.5%. |
| CGI-909 | Tetrabutylammonium-tris(3-chlor-4-methylphenyl)-(hexyl)borat, [1147315-11-4], Produkt der BASF SE. |

Farbstoff 1 (3,7-Bis(diethylamino)-phenoxazin-5-ium bis(2-ethylhexyl)sulfobernsteinsäureester) wurde wie in WO 2012062655 beschrieben hergestellt.

Polyol 1 entspricht Polyol 1 in WO2015091427 und wurde wie dort beschrieben hergestellt.

Urethanacrylat 1, (Phosphorothioyltris(oxybenzol-4,1-diylcarbamoyloxyethan-2,1-diyl)trisacrylat, [1072454-85-3]) wurde wie in WO2015091427 beschrieben hergestellt.

Urethanacrylat 2, (2-({[3-(Methylsulfanyl)phenyl]carbamoyl}oxy)-ethylprop-2-enoat ,[1207339-61-4]) wurde wie in WO2015091427 beschrieben hergestellt.

Additiv 1, Bis(2,2,3,3,4,4,5,5,6,6,7,7-dodecafluorheptyl)-(2,2,4-trimethylhexan-1,6-diyl)biscarbamat [1799437-41-4] wurde wie in WO2015091427 beschrieben hergestellt.

**Rohstoffe der Schicht C**

**Polyvinylalkohole**

| | |
|---|---|
| POVAL 60-98 - Harz 1 | Polyvinylalkohol der Fa. Kuraray Europe GmbH, Deutschland. Produkt mit Hydrolysegrad von 98 mol-% (gemäß DIN EN ISO 3681:2007-10-01) und mit der Viskosität von 60 mPas (gemessen als 4%-ige wässrige Lösung bei 20 °C nach DIN 53015:2001-02); |
| POVAL 25-88KL - Harz 2 | Polyvinylalkohol der Fa. Kuraray Europe GmbH, Deutschland. Produkt mit Hydrolysegrad von 88 mol-% (gemäß DIN EN ISO 3681:2007-10-01) und mit der Viskosität von 25 mPas (gemessen als 4%-ige wässrige Lösung bei 20 °C nach DIN 53015:2001-02). |

**Vernetzer für Polyvinylalkohol**

| | |
|---|---|
| Glyoxal-Lösung | [107-22-2] 40%(G/G) in Wasser Produkt der Fa. Sigma-Aldrich Chemie GmbH., Taufkirchen, Deutschland. |
| Borsäure | [10043-35-3] Produkt ReagentPlus® (≥ 99,5%) der Fa. Sigma-Aldrich Chemie GmbH, Taufkirchen, Deutschland. |

**Haftvermittler (optional)**

| | |
|---|---|
| Silquest VS 142 | Aminoalkoxysilanhydrolisat in Wasser. Produkt der Fa. Momentive Performance Materials, Albany, NY, USA |

**Tenside (optional)**

| | |
|---|---|
| 1-Octanol | [111-87-5] Produkt ReagentPlus® (99%) der Fa. Sigma-Aldrich Chemie GmbH., Taufkirchen, Deutschland. |

**Lösungsmittel der Schichten B und C**

| | |
|---|---|
| Butylacetat (BA) | Essigsäurebutylester der Brenntag GmbH, Mülheim an der Ruhr, Deutschland. |
| Ethylacetat (EA) | Essigsäureethylester der Brenntag GmbH, Mülheim an der Ruhr, Deutschland. |
| 2-Butanon | 2-Butanon der Brenntag GmbH, Mülheim an der Ruhr, Deutschland. |
| Wasser | deionisiertes Wasser. |

**Optical Clear Adhesives (OCA) der Schicht D**

| | |
|---|---|
| OCA 8211 -D01 | OCA 8211 Acrylic-Type OCA Produkt der Fa.3M, St. Paul, MN, USA. Schichtstärke der Klebstoffschicht 25 µm. 50µm-Polyester-Kaschierung. |
| OCA-69604 - D02 | OCA-69604, ein UV härtender Optical Clear Adhesive der Fa. Tesa SE, Norderstedt, Deutschland. Schichtstärke der Klebstoffschicht 100 µm. 50µm und 125µm-Polyester-Kaschierung. |

**Glassubstrate der Schicht E**

| | |
|---|---|
| Schott-Glas | Glasplatte der Maße 50 mm x 70 mm (3 mm Dicke). Produkt der Fa. Schott AG, Mainz, Deutschland |

**Herstellung holographischen Medien (Photopolymerfolie)**

7.90 g der oben beschriebenen Polyol-Komponente 1 wurden aufgeschmolzen und mit 7.65 g des jeweiligen Urethanacylats 2, 2.57 g des oben beschriebenen Urethanacrylats 1, 5.10 g des oben beschriebenen fluorierten Urethans (Additiv 1), 0.91 g CGI 909, 0.232 g des Farbstoff 1, 0.230 g BYK 310, 0.128 g Fomrez UL 28 und 3.789 g Ethylacetat gemischt, so dass eine klare Lösung erhalten wurde. Anschließend wurden 1.50 g Desmodur® N 3900 zugegeben und erneut gemischt.

Nun gab man diese Lösung in einer Rolle zu Rolle Beschichtungsanlage auf eine 36 µm dicke PET Folie, wo mittels eines Rakels das Produkt in einer Naßschichtdicke von 19 µm appliziert wurde. Bei einer Trocknungstemperatur von 85 °C und einer Trocknungszeit von 5 Minuten wurde die beschichtete Folie getrocknet und anschließend mit einer 40 µm dicken Polyethylenfolie geschützt. Anschließend wurde dieser Film (Photopolymerfolie mit Schichtaufbau A-B) lichtdicht verpackt.

**Herstellung der Schutzschicht bzw. Barriereschicht C auf der Photopolymerfolie A-B** Die in der Tabelle 1 angegebenen Formulierungen wurden derart hergestellt, dass die Polyvinylalkohol-Harze, gelöst bei 95°C in dem Wasser und abgekühlt bis Raumtemperatur , mit einem Vernetzer, Tensid und Haftvermittler (optional) gemischt wurden.

Tab. 1 Beschichtungsmittel* für die Herstellung der Schutzschichten C

| Erfindungsgemäße Beispiele | Polyvinylalkohol | Vernetzer | Haftvermittler | Gewichtsverhältnis zwischen Polyvinylalkohol, Vernetzer und ggf. Haftvermittler im Lack | Festkörper-Gehalt der wässrigen Beschichtungslösung [Gew,%] | Viskosität der Lösung bei 23°C [mPa*s] |
|---|---|---|---|---|---|---|
| C-01 | 60-98 | Glyoxal-Lösung | | 75/25 | 8 | 550 |
| C-02 | 25-88KL, | Borsäure | | 80/20 | 8 | 802 |
| C-03 | 25-88KL | Borsäure | Silquest VS142 | 80/18/2 | 7 | 10900 |
| *Alle Beschichtungsmittel beinhalten 5 ppm 1-Octanol | | | | | | |

Tab. 2-1 Holographische Folienverbünde für die Verklebung auf Glas

| Probe | Aufbau des Folienverbundes | Beschichtungs mittel C | Dicke der Schicht C [μm] | Lösungsmittelbeständigkeit (1h) der Schutzschicht C (bzw. B') gegen NEP/ MEK/Butanol/EA | Bemerkungen |
|---|---|---|---|---|---|
| Erfindungsgemäße Beispiele | | | | | |
| P-01 | A-B-C | C-01 | 8 | 2/0/0/0 | photoempfindlich |
| P-02 | A-B-C | C-02 | 8 | 0/0/0/0 | photoempfindlich |
| P-03 | A-B-C | C-03 | 7 | 3/0/0/0 | photoempfindlich |
| P-04 | A-B'-C | C-01 | 8 | 2/0/0/0 | nicht photoempfindlich |
| P-05 | A-B'-C | C-02 | 8 | 0/0/0/0 | nicht photoempfindlich |
| P-06 | A-B'-C | C-03 | 7 | 3/0/0/0 | nicht photoempfindlich |
| Nicht erfindungs gemäße Beispiele | | | | | |
| PN-01 | A-B | ohne | keine | nicht getestet | photoempfindlich |
| PN-02 | A-B' | ohne | keine | 5/5/1/5 (nach 10 min) | nicht photoempfindlich |

Die Beschichtungsmittel C-01 bis C-03 wurden in einer Rolle zu Rolle Beschichtungsanlage mittels eines Rakels auf die B-Seite der Photopolymerfolie A-B appliziert. Bei einer Trocknungstemperatur von 85 °C und einer Trocknungszeit von 10 Minuten wurde die beschichtete Folie getrocknet und anschließend mit einer 40 μm dicken Polyethylenfolie geschützt. Die Trockenschichtdicke betrug in der Regel 7-8 μm. Anschließend wurde dieser Film (Photopolymerfolie A-B-C) lichtdicht verpackt. Die dadurch entstandenen erfindungsgemäßen Proben P01 bis P03 mit der Struktur A-B-C ebenso wie die nicht erfindungsgemäße und zum Vergleich dienende Probe PN-01 mit der Struktur A-B sind in der Tabelle 2-1 zusammengefasst. B ist dabei eine unbelichtete Photopolymerschicht,.

**Bewertung der Lösungsmittelbeständigkeit von Schutzschicht C**

Die Lösungsmittelbeständigkeit der Beschichtungen wurde üblicherweise mit N-Ethyl-2-pyrrolidon (NEP), Methylethylketon (MEK), 1-Butanol und Ethylacetat (EA) in technischer Qualität geprüft. Die Lösungsmittel wurden mit einem durchnässten Wattebausch auf die Beschichtung aufgetragen und durch Abdecken gegen Verdunstung geschützt. Es wurde, wenn nicht anders beschrieben, eine Einwirkzeit von 60 Minuten bei ca. 23 °C eingehalten. Nach dem Ende der Einwirkzeit wird der Wattebausch entfernt und die Prüffläche mit einem weichen Tuch sauber gewischt. Die Abmusterung erfolgt sofort visuell und nach leichten Kratzen mit dem Fingernagel.

Folgende Stufen werden unterschieden:

- 0 = unverändert; keine Veränderung sichtbar; durch Kratzen nicht verletzbar.
- 1 = leichte Anquellung sichtbar, aber durch Kratzen nicht verletzbar.
- 2 = Veränderung deutlich sichtbar, durch Kratzen kaum verletzbar.
- 3 = merklich verändert nach festem Fingernageldruck oberflächlich zerstört.
- 4 = stark verändert nach festem Fingernageldruck bis zum Untergrund durchgekratzt.
- 5 = zerstört; schon beim Abwischen der Chemikalie wird der Lack zerstört; die Testsubstanz ist nicht entfernbar (eingefressen).

Innerhalb dieser Bewertung wird der Test mit den Kennzahlen 0 und 1 üblicherweise bestanden. Kennwerte > 1 stehen für ein "nicht bestanden".

Wie die entsprechende Spalte der Tabelle 2-1 zeigt, verzeichnen alle erfindungsgemäßen Beschichtungen aus Beschichtungsmittel C02 ein sehr hohes Maß der Lösungsmittelbeständigkeit. Ebenso stark zeigen sich die Beschichtungen aus Beschichtungsmittel C01 und C03 gegen Methylethylketon, Ethylacetat und Butanol. Etwa schwächer fallen

sie gegen das stark aprotische Lösungsmittel NEP aus. Trotzdem sind die Werte auch für NEP wesentlich besser als bei den Vergleichsproben ohne die Schutzschicht C.

**Herstellung eines Folienverbundes mit dem Schichtaufbau A-B-C-D-E**

Die Herstellung eines Folienverbundes mit dem Schichtaufbau A-B-C-D-E beinhaltet zuerst eine Laminierung der Seite C der Folie A-B-C auf die dekaschierte Klebstoffschicht D des OCAs, wodurch beide Schichten verbunden werden. Das erfolgt durch Zusammenpressen der beiden Folien zwischen den Gummiwalzen eines Laminators. Die Temperatur der Walzen wurde auf 30 °C eingestellt. Die hergestellte mehrschichtige Folie wurde aus Raumtemperatur abgekühlt. Von dem Folienverbund wurde dann die zweite Kaschierfolie des OCAs abgezogen. Auf die Seite D des Folienverbunds A-B-C-D wurde dann das Glassubstrat E laminiert. Die dadurch entstandenen erfindungsgemäßen Proben P07 bis P09 und P13 bis P15 mit dem Schichtaufbau A-B-C-D-E ebenso wie die nicht erfindungsgemäßen und zum Vergleich dienenden Proben PN-03 und PN-05 mit dem Schichtaufbau A-B-D-E sind in der Tab. 2-2 zusammengefasst. B ist dabei eine unbelichtete Photopolymerschicht.

Tab. 2-2: Zusammensetzung auf Glas verklebten photo-empfindlichen holographischen Folienverbünde und die nicht mehr photo-empfindlichen Folienverbünde mit einem einbelichteten und fixierten Hologramm

| Probe | Struktur des Folienverbundes | Beschichtungsmittel C | Optic clear adhesive | Bemerkungen |
|---|---|---|---|---|
| Erfindungsgemäße Beispiele | | | | |
| P-07 | A-B-C-D-E | C01 | D01 (3M) | photo empfindlich |
| P-08 | A-B-C-D-E | C02 | D01 (3M) | photo empfindlich |
| P-09 | A-B-C-D-E | C03 | D01 (3M) | photo empfindlich |
| P-10 | A-B'-C-D-E | C01 | D01 (3M) | nicht photoempfindlich |
| P-11 | A-B'-C-D-E | C02 | D01 (3M) | nicht photoempfindlich |
| P-12 | A-B'-C-D-E | C03 | D01 (3M) | nicht photoempfindlich |
| P-13 | A-B-C-D-E | C01 | D02 (Tesa) | photoempfindlich |
| P-14 | A-B-C-D-E | C02 | D02 (Tesa) | photoempfindlich |
| P-15 | A-B-C-D-E | C03 | D02 (Tesa) | photo empfindlich |
| P-16 | A-B'-C-D-E | C01 | D02 (Tesa) | nicht photoempfindlich |
| P-17 | A-B'-C-D-E | C02 | D02 (Tesa) | nicht photoempfindlich |
| P-18 | A-B'-C-D-E | C03 | D02 (Tesa) | nicht photoempfindlich |
| Nicht erfindungsgemäße Beispiele | | | | |
| PN-03 | A-B-D-E | ohne | D01 (3M) | photoempfindlich |
| PN-04 | A-B'-D-E | ohne | D01 (3M) | nicht photoempfindlich |
| PN-05 | A-B-D-E | ohne | D02 (Tesa) | photoempfindlich |
| PN-06 | A-B'-D-E | ohne | D02 (Tesa) | nicht photoempfindlich |

**Herstellung von Testhologrammen in den erfindungsgemäßen Folienverbünden A-B-C und A-B-C-D-E, bzw. in den nicht erfindungsgemäßen Folienverbünden A-B und A-B-D-E**

Die Testhologramme wurden wie folgt vorbereitet: die Photopolymerfolien mit dem Schichtaufbau A-B und A-B-C wurden im Dunkeln auf die gewünschte Größe zurechtgeschnitten und mit Hilfe einer Gummiwalze auf eine Glasplatte der Maße 50 mm x 70 mm (3 mm Dicke) auflaminiert. Die Folienverbünde A-B-C-D-E beinhalten schon diese Glasplatte als Schicht E und wurden so wie sie sind zum Test genommen. Die Herstellung von Testhologrammen erfolgt durch eine Testapparatur, die mittels grüner (532 nm) Laserstrahlung Denisyuk-Reflektionshologrammen erzeugt. Die Testapparatur besteht aus einer Laserquelle, einem optischen Strahlführungssystem und einer Halterung für die Glascoupons. Die Halterung für die Glascoupons ist mit einem Winkel von 13° relativ zur Strahlachse montiert. Die Laserquelle generierte die Strahlung, die über einen speziellen optischen Strahlengang auf ca. 5 cm geweitet zum Glascoupon

geführt wurde, der sich im optischen Kontakt zum Spiegel befand. Das holographierte Objekt war ein ca. 2 cm x 2 cm großer Spiegel, so dass bei der Rekonstruktion des Hologramms die Wellenfront des Spiegels rekonstruiert wurde. Alle Beispiele wurden mit einem grünen 532 nm Laser (Newport Corp, Irvine, CA, USA, Best.-Nr. EXLSR-532-50-CDRH) belichtet. Mittels Verschlussblende wurde der Aufzeichnungsfilm definiert für 2 Sekunden belichtet. So entsteht ein Folienverbund mit einem Hologramm in der Schicht B.

Anschließend wurden die Proben auf das Förderband eines UV-Strahlers gelegt und mit einer Bahngeschwindigkeit von 2,5 m/min zwei Mal belichtet. Als UV Strahler wurde eine eisendotierte Hg-Lampe vom Typ Fusion UV type "D Bulb" No. 558434 KR 85 mit 80 W / $cm^2$ Gesamtleistungsdichte verwendet. Die Parameter entsprachen einer Dosis von 2 x 2,5 J/$cm^2$ (gemessen mit einem Light Bug des Typs ILT 490). Nach diesem Fixierungsschritt entstehen die erfindungsgemäßen Folienverbünde A-B'-C (Tab. 2-1, Proben P04 bis P06) und A-B'-C-D-E (Tab .2-2, Proben P10 bis P12 und Proben P-16 bis P-18) und die nicht erfindungsgemäßen und zum Vergleich dienenden Folienverbünde A-B'(Tab. 2-1, Probe PN02) und A-B'-D-E (Tab. 2-2, Proben PN04 und PN06).

**Aufkleben der Hologramm beinhaltenden Folienverbünde A-B'-C, bzw. A-B' auf Glas (Alternative Herstellung des Folienverbund A-B'-C-D-E)**

In den früheren Abschnitten wurde beschrieben, wie die Folie A-B-C im Dunkeln mit der Kleberfolie D auf Glas (E) gepresst wurde und dann in den dadurch entstandenen A-B-C-D-E-Folienverbund das Hologramm einbelichtet und fixiert wurde.

Ein gleichwertiger Weg besteht darin, in den Folienverbund A-B-C ein Hologramm einzuschreiben und dann den dadurch entstandenen Folienverbund A-B'-C mit der Hilfe der Kleberfolie D auf Glas (E) zu pressen. In Falle des OCAs D02 wurde danach die eine früher beschriebene optische Fixierung vorgenommen.

Dadurch entstanden die erfindungsgemäßen Folienverbünde A-B'-C-D-E (Tab. 2-3, Proben P19 bis P24) und die nicht erfindungsgemäßen und zum Vergleich dienenden Folienverbünde A-B'-D-E (Tab. 2-3, Proben PN07 und PN08).

Tab. 2-3 Folienverbünde, die durch Verklebung von Glas und einem Folienverbund A-B'-C mit einem vorher angefertigten Hologramm entstanden sind

| Probe | Struktur des Folienverbundes | Beschichtungsmittel C | Optic clear adhesive | Zusätzliche UV-Härtung für optical clear adhesive |
|---|---|---|---|---|
| Erfindungsgemäße Beispiele | | | | |
| P-19 | A-B'-C-D-E | C01 | D01 (3M) | nein |
| P-20 | A-B'-C-D-E | C02 | D01 (3M) | nein |
| P-21 | A-B'-C-D-E | C03 | D01 (3M) | nein |
| P-22 | A-B'-C-D-E | C01 | D02 (Tesa) | ja |
| P-23 | A-B'-C-D-E | C02 | D02 (Tesa) | ja |
| P-24 | A-B'-C-D-E | C03 | D02 (Tesa) | ja |
| Nichterfindungsgemäße Beispiele | | | | |
| PN-07 | A-B'-D-E | ohne | D01 (3M) | nein |
| PN-08 | A-B'-D-E | ohne | D02 (Tesa) | ja |

**Charakterisierung der Testhologramme**

Die Hologramme in der Schicht B' der Folienverbünde A-B'-C, A-B'-C-D-E und A-B' wurden nun spektroskopisch auf ihre Qualität untersucht.

Die diffraktive Reflexion solcher Hologramme lässt sich aufgrund der hohen Beugungseffizienz des Volumenhologramms mit sichtbarem Licht mit einem Spektrometer (verwendet wurde ein Gerät vom Typ USB 2000, Ocean Optics, Dunedin, FL, USA) in Transmission analysieren und erscheint im Transmissionsspektrum als Peak mit reduzierter Transmission $T_{Red}$. Über die Auswertung der Transmissionskurve lässt sich die Qualität des Hologramms nach ISO-Norm 17901-1:2015(E) feststellen, dabei werden die folgenden Messgrößen betrachtet, alle Ergebnisse sind in den Tabellen 3-1 bis 3-3 und in den Tabellen 4-1 bis 4-3 in dem Abschnitt "Spektrale Qualität der Hologramme" zusammengefasst:

| | |
|---|---|
| $T_{Red}$=100-$T_{peak}$(2) | Maximale Tiefe des Transmissions-Peaks, dies entspricht der höchsten Beugungseffizienz. Somit dient 100-$T_{peak}$ als Maß für die Reflektionskraft (oder sichtbare "Stärke" oder "Qualität") des Hologramms. |
| FWHM | Die Breite des Transmissions-Peaks wird als "Full width at half maximum" (FWHM) in Nanometern (nm) bestimmt. |
| $\lambda_{peak}$ | Spekrale Lage des Transmissionsminimums des Hologramms in Nanometer (nm). |
| $\Delta\lambda_{peak}$ | Spektrale Verschiebung des Transmissionsminimums des Hologramms in Nanometer (nm) in Bezug auf der ersten Messung der Probe dargestellt in jeweiligen Zeile der Tabelle |

Die Qualität der erfindungsgemäßen Schutzschichten wurde bewertet, indem zunächst Testhologramme in das Photopolymer eingeschrieben wurden und die jeweils zu bewertenden Schichtaufbauten bei unterschiedlichen Bedingungen gelagert wurden. Die erhaltenen Ergebnisse sind in den Tabellen 3-1, 3-2, 3-3, 4-1, 4-2 und 4-3 zusammengefasst.

Die Tabellen 3-1, 3-2 und 3-3 stellen die Ergebnisse für die Hologrammen dar, die im A-B-C-D-E Folienverbund eingeschrieben und dann UV-VIS-fixiert wurden. D02 härtet dabei auch endgültig aus. Das frisch hergestellte Hologramm wurde spektroskopisch vermessen. Dann wurden Proben unterschiedlich lang unter diversen äußeren Bedingungen gelagert und danach das Hologramm erneut spektroskopisch vermessen.

Die Tabellen 4-1,4-2 und 4-3 fassen die Ergebnisse zusammen, bei denen Hologramme in den A-B-C Folienverbund eingeschrieben und dann UV-VIS-fixiert wurden. Die Hologramm des gebildeten Folienverbunds A-B’-C wurden spektroskopisch vermessen. Im Anschluss wurde ein Optical clear adhesive (OCA) auf die C-Schicht laminiert und die TrägerFolie des OCA wurde entfernt. Die Klebeseite des Folienverbundes wurde auf Glas laminiert und verklebt. Im Falle des Tesa-Produkts (D02) wird der Folienverbund zusätzlich UVausgehärtet. Der Folienverbund A-B’-C-D-E und die nicht erfindungsgemäßen Vergleich AB’-D-E wurden dann spektroskopisch vermessen, bei den angegebenen Bedingungen gelagert und erneut spektroskopisch vermessen.

**Folienverbünde A-B-C und A-B-C-D-E als holographische Aufzeichnungsmedien**

Das Aufbringen der Schutzschicht C auf die Folie A-B durch eine Rolle-zu-Rolle Beschichtung führt zum Folienverbund A-B-C, dessen Eignung zur Aufnahme von Hologrammen auf Grund der Ergebnisse in Tab. 3-1 bis 3-3 und 4-1 bis 4-3 bewertet werden kann.

Die Charakteristika der Hologramme, aufgenommen in den Standard-Folien A-B, sind in der Tabellen 4-1 bis 4-3 (Spalte "in A-B’’’) für die nicht erfindungsgemäßen Proben PN-07-01 bis PN-07-03 und PN-08-01 bis PN-08-03 dargestellt.

Die erfindungsgemäßen Proben P-19 bis P-24 (in den gleichen drei Tabellen - Spalte " in AB’-C ") zeigen die Hologramme mit gleicher Performance im Hinblick auf die Intensität (100-$T_{peak}$), die Peak-Breite (FWHM) und der Lage ($\lambda_{peak}$) des Peak-Maximums.

Das bedeutet, dass die Schutzschicht C die Aufnahmefähigkeiten der holographischen Folie A-B nicht beeinflusst. Als Aufnahmematerial für Hologramme sind die A-B-C-Folien den A-B-Folien gleichwertig.

Durch Verkleben solcher A-B-C-Folien mit einem OCA auf Glas entstehen nun die photo-empfindlichen Folienverbünde A-B-C-D-E, deren Performance zur Aufnahme der Hologramme auf Grund der Ergebnisse in Tab. 3-1 bis 3-3 und 4-1 bis 4-3 ebenso bewertet werden kann.

Die erfindungsgemäßen Proben P-10 bis P-18 (in den Tabellen 3-1 bis 3-3 - Spalte "in A-B’-C-D-E nach 5 min RT") zeigen die Hologramme mit gleichem Performance im Hinblick auf die Intensität (100-$T_{peak}$), die Peak-Breite (FWHM) und der Lage ($\lambda_{peak}$) des Peak-Maximums, wie die aus der A-B-C-Folien entstandenen oben beschriebenen erfindungsgemäßen Proben P-19 bis P-24 (in den Tabellen 4-1 bis 4-3 - Spalte "in A-B’-C").

Das bedeutet, dass die Schutzschicht C das Aufzeichnungsmedium B effektiv vor z.B. einer OCA-Schicht D schützt. Die erfindungsgemäßen Folienverbünde A-B-C-D-E, bei denen die photo-empfindliche erfindungsgemäße Folien A-B-C mit dem OCA auf Glas geklebt wurden, sind als holographische Aufzeichnungsmedien diesen noch nicht aufgeklebten Folien und den A-B-Folien ebenbürtig.

Ohne die Schutzschicht C lassen sich nur sehr schwache Hologramme mit stark verschobener Lage des spektralen Maximums in die Schicht B schreiben (nicht erfindungsgemäße Proben PN-04-01 bis PN-04-03 und PN-06-01 bis PN-06-03 (Tab. 3-1 bis 3-3 - Spalte "in AB’-D-E nach 5 min RT")). Diese Proben sind zudem nicht lagerungsstabil. Ohne die Schutzschicht C sind derart aufgebaute Folienverbünde nicht als Aufzeichnungsmedien brauchbar.

**Lagerungsstabilität der Folienverbünde A-B’-C-D-E**

Die Lagerungsstabilität der Folienverbünde A-B’-C-D-E kann durch die Qualität der in die Schicht B’ eingeschriebener Hologramme wie z. B. in den erfindungsgemäßen Beispielen P-10 bis P-18 beurteilt werden. Die Ergebnisse

von Lagerungen bei unterschiedlichen Bedingungen ist in den Tabellen 3-1 bis 3-3 zusammengefasst. Die Lagerung bei Raumtemperatur für die Dauer von einem Tag oder einer Woche (Tab. 3-1) verursacht keine bis nur sehr minimale Veränderung von Hologrammen. Die nicht erfindungsgemäßen Proben PN-04 und PN-06 ohne Schutzschicht C zeigen im Gegenteil schon bei diesen milden Bedingungen eine starke Veränderung der spektralen Eigenschaften der Hologramme, die schwächer (100-$T_{peak}$) werden und deren Absorptionsmaximum stark verschoben wird ($\Delta\lambda_{peak}$).

Die Tab. 3-2 zeigt die Ergebnisse der Lagerung bei 80°C (für eine Stunde sowie für drei Tage). Die Hologramme der erfindungsgemäßen Proben P-10 bis P-18 bleiben sehr stabil.

Die Tab. 3-3 zeigt die Ergebnisse der Lagerung von 80 °C und 95% relativer Luftfeuchte für 3 Tage. Die Hologramme der erfindungsgemäßen Proben P-10 bis P-18 bleiben auch unter diesen Bedingungen im Sinne ihrer Intensität gut erhalten und ihr Absorptionsmaximum verschiebt sich spektral geringfügig. Diese spektrale Verschiebung differenziert verschiedene Zusammensetzungen der Schutzschicht C. Die Variante C01 ist für derartige Lagerungsbedingungen besonders geeignet. Die Probe P-10-03 (Schutzschicht C01 in Kombination mit dem OCA D01 (Fa. 3M)) zeigt beispielsweise keinerlei spektral messbare Beeinflussung des Hologramms.

**Lagerungsstabilität der Folienverbünde A-B'-C, die später auf Glas aufgeklebt wurden.**

Die Lagerungsstabilität der auf solcher Weise hergestellten Folienverbünde A-B'-C-D-E kann durch die Qualität der in die Schicht B eingeschriebener Hologramme wie z.B. der erfindungsgemäßen Beispiele P-19 bis P-24 beurteilt werden. Die Ergebnisse von Lagerungen bei unterschiedlichen Bedingungen ist in den Tabellen 4-1 bis 4-3 zusammengefasst. Die Lagerung bei Raumtemperatur für die Dauer von einem Tag oder einer Woche (Tab. 4-1) verursacht keine bis nur sehr minimale Veränderung von Hologrammen. Die nicht erfindungsgemäßen Proben PN-07 und PN-08 ohne Schutzschicht C zeigen im Gegenteil schon bei diesen milden Bedingungen eine starke Veränderung der spektralen Eigenschaften der Hologramme, die schwächer (100-$T_{peak}$) werden und deren Absorptionsmaximum stark verschoben wird ($A\lambda_{peak}$).

Die Tab. 4-2 zeigt die Ergebnisse der Lagerung bei 80 °C (für eine Stunde sowie für drei Tage). Die Hologramme der erfindungsgemäßen Proben P-19 bis P-24 bleiben sehr stabil.

Die Tab. 4-3 zeigt die Ergebnisse der Lagerung von 80 °C und 95% relativer Luftfeuchte für 3 Tage. Die Hologramme der erfindungsgemäßen Proben P-19 bis P-24 bleiben auch unter diesen Bedingungen im Sinne ihrer Intensität gut erhalten und ihr Absorptionsmaximum verschiebt sich spektral geringfügig. Diese spektrale Verschiebung differenziert verschiedene Zusammensetzungen der Schutzschicht C. Die Variante C01 ist für derartige Lagerungsbedingungen besonders geeignet. Die Probe P-19-03 (Schutzschicht C01 in Kombination mit dem OCA D01 (Fa. 3M)) zeigt beispielsweise keinerlei spektral messbare Beeinflussung des Hologramms.

Tab. 3-1 Bewertung der Qualität der Schutzschicht C: Testhologramme wurden in den A-B-C-D-E -Folienverbund eingeschrieben, dann mit 5-10 J/cm² UV-VIS-fixiert und es bildet sich der Folienverbund A-B'-C-D-E. Die eingeschriebenen Hologramme wurden spektroskopisch vermessen, bei den angegebenen Bedingungen gelagert und erneut vermessen.

| Probe | Beschichtungsmittel C | OCA (Schicht D) | Spektrale Qualität der Hologramme | | | | | | | | | | |
|---|---|---|---|---|---|---|---|---|---|---|---|---|---|
| | | | in A-B'-C-D-E (nach 5 min RT) | | | in A-B'-C-D-E (nach 1 Tag RT) | | | | in A-B'-C-D-E (nach 1 Woche RT) | | | |
| | | | 100-$T_{peak}$ [%] | FWHM [nm] | $\lambda_{peak}$ [nm] | 10-$T_{peak}$ [%] | FWHM [nm] | $\lambda_{peak}$ [nm] | $\Delta\lambda_{peak}$ [nm] | 100-$T_{peak}$ [%] | FWHM [nm] | $\lambda_{peak\ A}$ [nm] | $\Delta\lambda_{peak}$ [nm] |
| Erfindungsgemäße Beispiele | | | | | | | | | | | | | |
| P-10-01 | C01 | D01 (3M) | 73.5 | 14.8 | 530.4 | 82.0 | 15.0 | 529.7 | -0.7 | 81.1 | 14.8 | 529.0 | -1.4 |
| P-11-01 | C02 | D01 (3M) | 76.3 | 14.5 | 531.4 | 65.4 | 18.7 | 530.4 | -1.0 | 65.8 | 18.4 | 529.7 | -1.7 |
| P-12-01 | C03 | D01 (3M) | 78.1 | 16.0 | 530.4 | 77.7 | 16.6 | 530.0 | -0.4 | 75.1 | 15.7 | 529.3 | -1.1 |
| P-16-01 | C01 | D02 (Tesa)* | 78.1 | 15.5 | 529.7 | 76.9 | 15.4 | 529.4 | -0.3 | 76.2 | 15.2 | 529.4 | -0.3 |
| P-17-01 | C02 | D02 (Tesa)* | 74.2 | 15.9 | 529.7 | 76.0 | 16.9 | 529.7 | 0 | 77.1 | 17.1 | 529.7 | 0 |
| P-18-01 | C03 | D02 (Tesa)* | 74.8 | 16.3 | 529.4 | 74.9 | 16.2 | 529.7 | 0.3 | 69.7 | 16.0 | 529.4 | 0 |
| Nicht erfindungsgemäße Beispiele | | | | | | | | | | | | | |
| | | | in A-B'-D-E (nach 5 min RT) | | | in A-B'-D-E (nach 1 Tag RT) | | | | in A-B'-D-E (nach 1 Woche RT) | | | |
| PN-04-01 | ohne | D01 (3M) | 63.9 | 15.3 | 508.0 | 36.0 | 12.5 | 460.7 | -47.3 | 32.8 | 14.2 | 472.4 | -35.6 |
| PN-06-01 | ohne | D02 (Tesa)* | 26.5 | 16.5 | 527.6 | 19.2 | 17.6 | 501.4 | -26.2 | 17.8 | 18.1 | 491.9 | -35.7 |
| * D02 härtet ebenfalls durch Belichtung aus | | | | | | | | | | | | | |

Tab. 3-2 Bewertung der Qualität der Schutzschicht C: Testhologramme wurden in den A-B-C-D-E -Folienverbund eingeschrieben, dann mit 5-10 J/cm² UV-VIS-fixiert und es bildet sich der Folienverbund A-B'-C-D-E. Die eingeschriebenen Hologramme wurden spektroskopisch vermessen, bei den angegebenen Bedingungen gelagert und erneut vermessen.

| Probe | Beschichtungsmittel C | OCA (Schicht D) | Spektrale Qualität der Hologramme | | | | | | | | | | |
|---|---|---|---|---|---|---|---|---|---|---|---|---|---|
| | | | in A-B'-C-D-E (nach 5 min RT) | | | in A-B'-C-D-E (nach 1h; 80°C) | | | | in A-B'-C-D-E (nach 3 Tagen; 80°C) | | | |
| | | | 100-$T_{peak}$ [%] | FWHM [nm] | $\lambda_{peak}$ [nm] | 100-$T_{peak}$ [%] | FWHM [nm] | $\lambda_{peak}$ [nm] | $\Delta\lambda_{peak}$ [nm] | 100-$T_{peak}$ [%] | FWHM [nm] | $\lambda_{peak}$ [nm] | $\Delta\lambda_{peak}$ [nm] |
| Erfindungsgemäße Beispiele | | | | | | | | | | | | | |
| P-10-02 | C01 | D01 (3M) | 73.6 | 14.9 | 530.4 | 77.4 | 15.2 | 532.8 | 2.4 | 77.9 | 15.3 | 533.2 | 2.8 |
| P-11-02 | C02 | D01 (3M) | 76.3 | 14.6 | 531.5 | 78.7 | 16.4 | 531.4 | -0.1 | 78.0 | 16.4 | 532.5 | 1.0 |
| P-12-02 | C03 | D01 (3M) | 78.1 | 16.1 | 530.4 | 76.5 | 16.3 | 532.1 | 1.7 | 78.8 | 16.6 | 532.8 | 2.4 |
| P-16-02 | C01 | D02 (Tesa)* | 71.3 | 14.8 | 529.4 | 75.7 | 16.3 | 533.2 | 3.8 | 70.6 | 16.2 | 532.5 | 3.1 |
| P-17-02 | C02 | D02 (Tesa)* | 74.9 | 15.9 | 529.7 | 76.8 | 17.3 | 533.2 | 3.5 | 74.6 | 16.9 | 532.9 | 3.2 |
| P-18-02 | C03 | D02 (Tesa)* | 71.4 | 16.5 | 529.7 | 69.4 | 16.4 | 532.9 | 3.2 | 67.5 | 16.6 | 531.8 | 2.1 |
| Nicht erfindungsgemäße Beispiele | | | | | | | | | | | | | |
| | | | in A-B'-D-E (nach 5 min RT) | | | in A-B'-D-E (nach 1h; 80°C) | | | | in A-B'-D-E (nach 3 Tagen; 80°C) | | | |
| PN-04-02 | ohne | D01 (3M) | 63.9 | 15.4 | 508.1 | 42.7 | 11.8 | 440.0 | -68.1 | 39.6 | 11.7 | 446.8 | -61.3 |
| PN-06-02 | ohne | D02 (Tesa)* | 30.3 | 14.5 | 525.5 | 22.4 | 20.5 | 488.4 | -37.1 | 18.2 | 14.6 | 485.9 | -39.6 |
| * D02 härtet ebenfalls durch Belichtung aus | | | | | | | | | | | | | |

Tab. 3-3 Bewertung der Qualität der Schutzschicht C: Testhologramme wurden in den A-B-C-D-E -Folienverbund eingeschrieben, dann mit 5-10 $J/cm^2$ UV-VIS-fixiert und es bildet sich der Folienverbund A-B'-C-D-E. Die eingeschriebenen Hologramme wurden spektroskopisch vermessen, bei den angegebenen Bedingungen gelagert und erneut vermessen.

| Probe | Beschichtungsmittel C | OCA (Schicht D) | Spektrale Qualität der Hologramme | | | | | | |
|---|---|---|---|---|---|---|---|---|---|
| | | | in A-B'-C-D-E (nach 5 min RT) | | | in A-B'-C-D-E (nach 3 Tagen; 80°C; 95% LF) | | | |
| | | | 100-$T_{peak}$ [%] | FWHM [nm] | $\lambda_{peak}$ [nm] | 100-$T_{peak}$ [%] | FWHM [nm] | $\lambda_{peak}$ [nm] | $\Delta\lambda_{peak}$ [nm] |
| Erfindungsgemäße Beispiele | | | | | | | | | |
| P-10-03 | C01 | D01 (3M) | 78.4 | 14.5 | 528.7 | 79.2 | 16.0 | 531.1 | 2.4 |
| P-11-03 | C02 | D01 (3M) | 52.5 | 17.9 | 530.1 | 60.5 | 17.5 | 518.6 | -11.5 |
| P-12-03 | C03 | D01 (3M) | 74.6 | 15.8 | 529.4 | 70.4 | 15.1 | 515.8 | -13.6 |
| P-16-03 | C01 | D02 (Tesa)* | 75.0 | 16.2 | 529.4 | 78.1 | 16.4 | 526.9 | -2.5 |
| P-17-03 | C02 | D02 (Tesa)* | 70.6 | 15.8 | 529.7 | 75.2 | 15.7 | 519.6 | -10.1 |
| P-18-03 | C03 | D02 (Tesa)* | 75.1 | 15.6 | 529.7 | 66.5 | 14.6 | 518.2 | -11.5 |
| Nicht erfindungsgemäße Beispiele | | | | | | | | | |
| | | | in A-B'-D-E (nach 5 min RT) | | | in A-B'-D-E (nach 3 Tage; 80°C; 95% LF) | | | |
| PN-04-03 | ohne | D01 (3M) | 31.6 | 12.8 | 470.4 | 13.0 | # | 400.1 | -70.3 |
| PN-06-03 | ohne | D02 (Tesa)* | 19.5 | 15.1 | 524.2 | 7.1 | 19.8 | 497.9 | -26.3 |
| * D02 härtet ebenfalls durch Belichtung aus | | | | | | | | | |

Tab. 4-1 Bewertung der Qualität der Schutzschicht C: Testhologramme wurden in den A-B-C -Folienverbund eingeschrieben, dann mit 5-10 J/cm² UV-VIS-fixiert und es bildet sich der Folienverbund A-B'-C. Auf diesen Folienverbund wurde das genannte Optical clear adhesive (OCA) laminiert und die Träger-Folie des OCA wurde entfernt. Die Klebeseite des Folienverbundes A-B'-C-D wurde auf Glas laminiert. Die Hologramme wurden vor und nach der Lagerung bei den angegebenen Bedingungen spektroskopisch vermessen.

| Probe | Beschichtungsmittel C | OCA (Schicht D) | Spektrale Qualität der Hologramme | | | | | | | | | | |
|---|---|---|---|---|---|---|---|---|---|---|---|---|---|
| | | | in A-B'-C | | | in A-B'-C-D-E (nach 1h RT) | | | | in A-B'-C-D-E (nach 1 Woche RT) | | | |
| | | | 100-$T_{peak}$ [%] | FWHM [nm] | $\lambda_{peak}$ [nm] | 100-$T_{peak}$ [%] | FWHM [nm] | $\lambda_{peak}$ [nm] | $\Delta\lambda_{peak}$ zu A-B'-C [nm] | 100-$T_{peak}$ [%] | FWHM [nm] | $\lambda_{peak}$ [nm] | $\Delta\lambda_{peak}$ zu A-B'-C [nm] |
| Erfindungsgemäße Beispiele | | | | | | | | | | | | | |
| P-19-01 | C01 | D01 (3M) | 73.8 | 14.7 | 529.4 | 70.7 | 14.9 | 528.7 | -0.7 | 69.8 | 14.9 | 530.1 | 0.7 |
| P-20-01 | C02 | D01 (3M) | 75.6 | 15.9 | 529.7 | 81.0 | 16.5 | 529.4 | -0.3 | 74.2 | 15.5 | 530.4 | 0.7 |
| P-21-01 | C03 | D01 (3M) | 78.7 | 15.8 | 530.8 | 77.5 | 15.5 | 530.4 | -0.4 | 79.0 | 15.8 | 531.1 | 0.3 |
| P-22-01 | C01 | D02 (Tesa) | 66.1 | 16.6 | 530.4 | 62.2 | 16.1 | 530.8 | 0.4 | 53.5 | 15.1 | 530.4 | 0 |
| P-23-01 | C02 | D02 (Tesa) | 65.9 | 17.4 | 529.4 | 67.6 | 17.8 | 529.7 | 0.3 | 67.2 | 16.4 | 529.7 | 0.3 |
| P-24-01 | C03 | D02 (Tesa) | 72.3 | 16.8 | 529.7 | 74.7 | 17.2 | 530.1 | 0.4 | 73.8 | 17.4 | 530.1 | 0.4 |
| Nicht erfindungsgemäße Beispiele | | | | | | | | | | | | | |
| | | | in A-B' | | | in A-B'-D-E (nach 1h RT) | | | | in A-B'-D-E (nach 1 Woche RT) | | | |
| PN-07-01 | ohne | D01 (3M) | 72.9 | 15.9 | 529.7 | 65.5 | 16.3 | 522.4 | -5.3 | 42.0 | 10.45 | 442.9 | -86.8 |
| PN-08-01 | ohne | D02 (Tesa) | 56.7 | 14.7 | 529.4 | 47.1 | 4.6 | 517.5 | -11.9 | 30.1 | 12.4 | 442.9 | -86-5 |
| * D02 härtet ebenfalls durch Belichtung aus | | | | | | | | | | | | | |

Tab. 4-2 Bewertung der Qualität der Schutzschicht C: Testhologramme wurden in den A-B-C -Folienverbund eingeschrieben, dann mit 5-10 J/cm$^2$ UV-VIS-fixiert und es bildet sich der Folienverbund A-B'-C. Auf diesen Folienverbund wurde das genannte Optical clear adhesive (OCA) laminiert und die Träger-Folie des OCA wurde entfernt. Die Klebeseite des Folienverbundes A-B'-C-D wurde auf Glas laminiert. Die Hologramme wurden vor und nach der Lagerung bei den angegebenen Bedingungen spektroskopisch vermessen.

| Probe | Beschichtungsmittel C | OCA (Schicht D) | Spektrale Qualität der Hologramme | | | | | | | | | | |
|---|---|---|---|---|---|---|---|---|---|---|---|---|---|
| | | | in A-B'-C | | | in A-B'-C-D-E (nach 1h 80°C) | | | | in A-B'-C-D-E (nach 3 Tagen 80°C) | | | |
| | | | 100-$T_{peak}$ [%] | FWHM [nm] | $\lambda_{peak}$ [nm] | 100-$T_{peak}$ [%] | FWHM [nm] | $\lambda_{peak}$ [nm] | $\Delta\lambda_{peak}$ zu A-B'-C [nm] | 100-$T_{peak}$ [%] | FWHM [nm] | $\lambda_{peak}$ [nm] | $\Delta\lambda_{peak}$ zu A-B'-C [nm] |
| Erfindungsgemäße Beispiele | | | | | | | | | | | | | |
| P-19-02 | C01 | D01 (3M) | 72.7 | 15.0 | 529.0 | 74.4 | 15.2 | 535.6 | 6.6 | 71.2 | 15.0 | 533.8 | 4.8 |
| P-20-02 | C02 | D01 (3M) | 83.1 | 15.5 | 530.0 | 78.9 | 15.7 | 531.4 | 1.4 | 78.9 | 14.9 | 531.1 | 1.1 |
| P-21-02 | C03 | D01 (3M) | 80.5 | 16.3 | 530.0 | 78.8 | 16.1 | 534.2 | 4.2 | 74.3 | 15.3 | 533.8 | 3.8 |
| P-22-02 | C01 | D02 (Tesa) | 65.4 | 15.4 | 529.7 | 67.1 | 16.3 | 534.6 | 4.9 | 68.4 | 16.2 | 533.9 | 4.2 |
| P-23-02 | C02 | D02 (Tesa) | 67.8 | 16.9 | 530.8 | 37.1 | 19.3 | 532.9 | 2.1 | 46.3 | 18.1 | 531.1 | 0.3 |
| P-24-02 | C03 | D02 (Tesa) | 74.6 | 16.0 | 529.4 | 76.2 | 17.1 | 531.8 | 2.4 | 76.1 | 16.8 | 530.8 | 1.4 |
| Nicht erfindungsgemäße Beispiele | | | | | | | | | | | | | |
| | | | in A-B' | | | in A-B'-D-E (nach 1h 80°C) | | | | in A-B'-D-E (nach 3 Tage 80°C) | | | |
| PN-07-02 | ohne | D01 (3M) | 74.1 | 17.2 | 528.3 | 37.4 | 11.1 | 440.4 | -87.9 | 37.5 | 12.2 | 449.7 | -78.6 |
| PN-08-02 | ohne | D02 (Tesa) | 74.0 | 15.6 | 528.7 | 33.5 | 12.2 | 438.6 | -90.1 | 30.5 | 12.1 | 444.4 | -84.3 |
| * D02 härtet ebenfalls durch Belichtung aus | | | | | | | | | | | | | |

Tab. 4-3 Bewertung der Qualität der Schutzschicht C: Testhologramme wurden in den A-B-C -Folienverbund eingeschrieben, dann mit 5-10 J/cm$^2$ UV-VIS-fixiert und es bildet sich der Folienverbund A-B'-C. Auf diesen Folienverbund wurde das genannte Optical clear adhesive (OCA) laminiert und die Träger-Folie des OCA wurde entfernt. Die Klebeseite des Folienverbundes A-B'-C-D wurde auf Glas laminiert. Die Hologramme wurden vor und nach der Lagerung bei den angegebenen Bedingungen spektroskopisch vermessen.

| Probe | Beschichtungsmittel C | OCA (Schicht D) | Spektrale Qualität der Hologramme | | | | | | |
|---|---|---|---|---|---|---|---|---|---|
| | | | in A-B'-C | | | in A-B'-C-D-E (nach 3 Tagen 80°C; 95% LF) | | | |
| | | | 100-$T_{peak}$ [%] | FWHM [nm] | $\lambda_{peak}$ [nm] | 100-$T_{peak}$ [%] | FWHM [nm] | $\lambda_{peak}$ [nm] | $\Delta\lambda_{peak}$ zu A-B'-C [nm] |
| Erfindungsgemäße Beispiele | | | | | | | | | |
| P-19-03 | C01 | D01 (3M) | 73.1 | 14.4 | 529.0 | 62.4 | 13.6 | 533.2 | 4.2 |
| P-20-03 | C02 | D01 (3M) | 80.9 | 15.6 | 529.3 | 76.8 | 15.7 | 522.0 | -7.3 |
| P-21-03 | C03 | D01 (3M) | 75.0 | 14.8 | 530.7 | 74.4 | 14.7 | 522.0 | -8.7 |
| P-22-03 | C01 | D02 (Tesa)* | 71.9 | 15.4 | 531.1 | 77.3 | 15.9 | 527.6 | -3.5 |
| P-24-03 | C03 | D02 (Tesa)* | 75.1 | 16.7 | 528.7 | 74.6 | 16.1 | 519.6 | -9.1 |
| Nichterfindungsgemäße Beispiele | | | in A-B' | | | in A-B'-D-E (nach 3 Tagen 80°C; 95% LF) | | | |
| PN-07-03 | ohne | D01 (3M) | 67.4 | 17.5 | 525.9 | 10.2 | # | 430.0 | -95.9 |
| PN-08-03 | ohne | D02 (Tesa)* | 65.4 | 15.1 | 529.4 | 31.5 | 11.1 | 452.2 | -77.2 |
| * D02 härtet ebenfalls durch Belichtung aus | | | | | | | | | |

**Patentansprüche**

1. Schichtaufbau umfassend eine flächig vorliegende Photopolymerschicht B und eine zumindest teilweise gehärtete Schutzschicht C, erhältlich durch Umsetzung einer wässrigen Zusammensetzung umfassend

   (I) mindestens einen Polyvinylalkohol,
   (II) mindestens einen Vernetzer für Polyvinylalkohole,
   (III) gegebenenfalls mindestens einen Haftvermittler, wobei der Haftvermittler vorzugsweise mindestens ein Hydrolysat eines Aminoalkyl-trialkoxysilans ist, und
   (IV) gegebenenfalls mindestens ein Tensid,

   wobei die Photopolymerschicht B zumindest teilweise mit der Schicht C verbunden ist.

2. Kit-of-parts enthaltend mindestens eine flächig vorliegende Photopolymerschicht und eine wässrige Zusammensetzung zur Erzeugung einer zumindest teilweise gehärteten Schutzschicht C, wobei die wässrige Zusammensetzung

   (I) mindestens einen Polyvinylalkohol,
   (II) mindestens einen Vernetzer für Polyvinylalkohole,
   (III) gegebenenfalls mindestens einen Haftvermittler, wobei der Haftvermittler vorzugsweise mindestens ein Hydrolysat eines Aminoalkyl-trialkoxyilans ist, und
   (IV) gegebenenfalls mindestens ein Tensid umfasst und

wobei die Photopolymerschicht B gegebenenfalls auf einer Substratschicht A vorliegt.

3. Kit-of-parts nach Anspruch 2, weiterhin enthaltend eine Klebstoffschicht D und eine Substratschicht E.

4. Schichtaufbau nach Anspruch 1 oder Kit-of-parts nach Anspruch 2 oder 3, **dadurch gekennzeichnet, dass** die Photopolymerschicht B eine unbelichtete Photopolymerschicht ist umfassend

I) Matrixpolymere,
II) Schreibmonomere,
III) Photoinitiatoren,
IV) gegebenenfalls mindestens eine nicht photopolymerisierbare Komponente, und
V) gegebenenfalls Katalysatoren, Radikalstabilisatoren, Lösungsmittel, Additive sowie andere Hilfs- und/oder Zusatzstoffe, oder die Photopolymerschicht B

eine teilbelichtete Photopolymerschicht ist, enthaltend ein Hologramm, vorzugsweise ein Volumenhologramm, wobei das Volumenhologramm vorzugsweise ausgewählt ist aus der Gruppe bestehend aus In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen und holographischen Stereogrammen.

5. Schichtaufbau nach Anspruch 1 oder 4, **dadurch gekennzeichnet, dass** der Schichtaufbau weiterhin eine Substratschicht A enthält, wobei die Photopolymerschicht B auf einer Seite zumindest teilweise mit der Substratschicht A verbunden ist und auf der gegenüberliegenden Seite zumindest teilweise mit der Schutzschicht C verbunden ist.

6. Schichtaufbau nach Anspruch 1, 4 oder 5, **dadurch gekennzeichnet, dass** der Schichtaufbau weiterhin eine Klebstoffschicht D enthält, wobei die Schutzschicht C auf einer Seite zumindest teilweise mit der Klebstoffschicht D verbunden ist und auf der gegenüberliegenden Seite zumindest teilweise mit der Photopolymerschicht B verbunden ist.

7. Schichtaufbau nach Anspruch 6, **dadurch gekennzeichnet, dass** der Schichtaufbau weiterhin eine Substratschicht E enthält, wobei die Klebstoffschicht D auf einer Seite zumindest teilweise mit der Substratschicht E verbunden ist und auf der gegenüberliegenden Seite zumindest teilweise mit Schutzschicht C verbunden ist.

8. Verfahren zur Herstellung eines Schichtaufbaus nach einem der Ansprüche 1 oder 4-7, **dadurch gekennzeichnet, dass** zunächst eine zumindest teilweise gehärtete Schutzschicht C auf eine Photopolymerschicht B aufgebracht wird, wobei die Photopolymerschicht B gegebenenfalls auf einer Substratschicht A vorliegt, um einen Schichtverbund B-C bzw. A-B-C zu ergeben, wobei die Schutzschicht C durch Umsetzung einer wässrigen Zusammensetzung umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid
erhältlich ist.

9. Verfahren nach Anspruch 8, **dadurch gekennzeichnet, dass** in einem weiteren nachfolgenden Schritt eine Klebstoffschicht D auf die zumindest teilweise gehärtete Schutzschicht C aufgebracht wird, um einen Schichtverbund B-C-D bzw. A-B-C-D zu ergeben und danach in einem weiteren darauffolgenden Schritt eine Substratschicht E auf die Klebstoffschicht D aufgebracht wird um einen Schichtverbund B-C-D-E bzw. A-B-C-D-E zu ergeben.

10. Verfahren nach einem der Ansprüche 8 oder 9, **dadurch gekennzeichnet, dass** in den Schichtverbund B-C, A-B-C, B-C-D, A-B-C-D, B-C-D-E oder A-B-C-D-E ein Hologramm einbelichtet und fixiert wird.

11. Schichtaufbau nach einem der Ansprüche 1 oder 4-7, Verfahren nach einem der Ansprüche 8-10 oder Kit-of-part nach einem der Ansprüche 2-4, **dadurch gekennzeichnet, dass** der mindestens eine Polyvinylalkohol nach DIN 53015:2001-02 als 4 Gew.-%-ige Lösung in Wasser bei 20° C eine Viskosität von ≥25 mPa*s, vorzugsweise ≥50 mPa*s aufweist, und wobei der Polyvinylalkohol vorzugsweise nach DIN EN ISO 3681:2007-10-01 einen Hydrolysegrad von ≥ 85 mol-%, bevorzugter ≥ 95 mol-% aufweist.

**12.** Schichtaufbau nach einem der Ansprüche 1, 4-7 oder 11, Verfahren nach einem der Ansprüche 8-11 oder Kit-of-part nach einem der Ansprüche 2-4 oder 11, **dadurch gekennzeichnet, dass** der Vernetzer für Polyvinylalkohole ausgewählt ist aus der Gruppe bestehend aus wässriger Glyoxal-Lösung, Glutaraldehyd, Oxalsäure, N,N'-Dimethylharnstoff, Magnesiumhydroxid, Calciumhydroxid, Borsäure, Borsäuresalzen, Aluminaten, Aluminiumsulfat, Kieselsäure, Kieselsäureester und / oder Kombinationen aus mindestens zweien davon.

**13.** Verwendung des Kit-of-parts nach einem der Ansprüche 2-4, 11 oder 12 oder des Schichtaufbau nach einem der Ansprüche 1, 4-7, 11 oder 12 für das Verfahren nach einem der Ansprüche 8-12.

**14.** Verwendung einer zumindest teilweise gehärteten Schutzschicht C zum Schutz einer Photopolymerschicht B, wobei die Schutzschicht C erhältlich ist durch Umsetzung einer wässrigen Zusammensetzung umfassend

(I) mindestens einen Polyvinylalkohol,
(II) mindestens einen Vernetzer für Polyvinylalkohole,
(III) gegebenenfalls mindestens einen Haftvermittler, wobei der Haftvermittler vorzugsweise mindestens ein Hydrolysat eines Aminoalkyl-trialkoxyilans ist, und
(IV) gegebenenfalls mindestens ein Tensid.

**15.** Verwendung des Schichtaufbaus nach einem der Ansprüche 1, 4-7, 11 oder 12 als holographisches Aufzeichnungsmedium.

**16.** Optische Anzeige, umfassend einen Schichtaufbau enthaltend ein Hologramm nach einem der Ansprüche 1, 4-7, 11 oder 12, wobei die optische Anzeige vorzugsweise ausgewählt ist aus der Gruppe bestehend aus Autostereoskopische und/oder holographische Displays, Projektionsleinwände, Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln.

**17.** Sicherheitsdokument, umfassend einen Schichtaufbau enthaltend ein Hologramm nach einem der Ansprüche 1, 4-7, 11 oder 12.

## Claims

**1.** Layer construction comprising an areal photopolymer layer B and an at least partly cured protective layer C obtainable by reaction of an aqueous composition comprising

(I) at least one polyvinyl alcohol,
(II) at least one crosslinker for polyvinyl alcohols,
(III) optionally at least one adhesion promoter, wherein the adhesion promoter is preferably at least one hydrolyzate of an aminoalkyl trialkoxysilane and
(IV) optionally at least one surfactant,

wherein the photopolymer layer B is at least partly joined to the layer C.

**2.** Kit of parts containing at least one areal photopolymer layer and an aqueous composition for generating an at least partly cured protective layer C, wherein the aqueous composition comprises

(I) at least one polyvinyl alcohol,
(II) at least one crosslinker for polyvinyl alcohols,
(III)optionally at least one adhesion promoter, wherein the adhesion promoter is preferably at least one hydrolyzate of an aminoalkyl trialkoxysilane and
(IV) optionally at least one surfactant and

wherein the photopolymer layer B is optionally disposed atop a substrate layer A.

**3.** Kit of parts according to Claim 2, further containing an adhesives layer D and a substrate layer E.

4. Layer construction according to Claim 1 or kit of parts according to Claim 2 or 3, **characterized in that** the photopolymer layer B is an unirradiated photopolymer layer comprising

I) matrix polymers,
II) writing monomers,
III) photoinitiators,
IV) optionally at least one non-photopolymerizable component and
V) optionally catalysts, free-radical stabilizers, solvents, additives and other assistant and/or added substances,
or the photopolymer layer B is a semi-irradiated photopolymer layer containing a hologram, preferably a volume hologram, wherein the volume hologram is preferably selected from the group consisting of in-line holograms, off-axis holograms, full-aperture transfer holograms, white light transmission holograms, Denisyuk holograms, off-axis reflection holograms, edge-lit holograms and holographic stereograms.

5. Layer construction according to Claim 1 or 4, **characterized in that** the layer construction further contains a substrate layer A, wherein the photopolymer layer B is on one side at least partly joined to the substrate layer A and is on the opposite side at least partly joined to the protective layer C.

6. Layer construction according to Claim 1, 4 or 5, **characterized in that** the layer construction further contains an adhesives layer D, wherein the protective layer C is on one side at least partly joined to the adhesives layer D and is on the opposite side at least partly joined to the photopolymer layer B.

7. Layer construction according to Claim 6, **characterized in that** the layer construction further contains a substrate layer E, wherein the adhesives layer D is on one side at least partly joined to the substrate layer E and is on the opposite side at least partly joined to protective layer C.

8. Process for producing a layer construction according to any of Claims 1 or 4-7, **characterized in that** initially an at least partly cured protective layer C is applied atop a photopolymer layer B, wherein the photopolymer layer B is optionally disposed atop a substrate layer A, to afford a layer composite B-C or A-B-C, wherein the protective layer C is obtainable by reaction of an aqueous composition comprising

(I) at least one polyvinyl alcohol,
(II) at least one crosslinker for polyvinyl alcohols,
(III) optionally at least one adhesion promoter, wherein the adhesion promoter is preferably at least one hydrolyzate of an aminoalkyl trialkoxysilane and
(IV) optionally at least one surfactant.

9. Process according to Claim 8, **characterized in that** in a further subsequent step an adhesives layer D is applied atop the at least partly cured protective layer C to afford a layer composite B-C-D or A-B-C-D and thereafter in a further subsequent step a substrate layer E is applied atop the adhesives layer D to afford a layer composite B-C-D-E or A-B-C-D-E.

10. Process according to either of Claims 8 or 9, **characterized in that** a hologram is photoinscribed and fixed into the layer composite B-C, A-B-C, B-C-D, A-B-C-D, B-C-D-E oder A-B-C-D-E.

11. Layer construction according to any of Claims 1 or 4-7, process according to any of Claims 8-10 or kit of parts according to any of Claims 2-4, **characterized in that** the at least one polyvinyl alcohol according to DIN 53015:2001-02 as a 4% by weight solution in water at 20°C has a viscosity of ≥ 25 mPa*s, preferably ≥ 50 mPa*s, and wherein the polyvinyl alcohol preferably according to DIN EN ISO 3681:2007-10-01 has a degree of hydrolysis of ≥ 85 mol%, more preferably ≥ 95 mol%.

12. Layer construction according to any of Claims 1, 4-7 or 11, process according to any of Claims 8-11 or kit of parts according to any of Claims 2-4 or 11, **characterized in that** the crosslinker for polyvinyl alcohols is selected from the group consisting of aqueous glyoxal solution, glutaraldehyde, oxalic acid, N,N'-dimethylurea, magnesium hydroxide, calcium hydroxide, boric acid, borate salts, aluminates, aluminum sulfate, silicic acid, silicic esters and/or combinations of at least two of these.

13. Use of the kit of parts according to any of Claims 2-4, 11 or 12 or of the layer construction according to any of Claims 1, 4-7, 11 or 12 for the process according to any of Claims 8-12.

**14.** Use of an at least partly cured protective layer C for protection of a photopolymer layer B, wherein the protective layer C is obtainable by reaction of an aqueous composition comprising

(I) at least one polyvinyl alcohol,
(II) at least one crosslinker for polyvinyl alcohols,
(III) optionally at least one adhesion promoter, wherein the adhesion promoter is preferably at least one hydrolyzate of an aminoalkyl trialkoxysilane and
(IV) optionally at least one surfactant.

**15.** Use of the layer construction according to any of Claims 1, 4-7, 11 or 12 as a holographic recording medium.

**16.** Optical display comprising a layer construction containing a hologram according to any of Claims 1, 4-7, 11 or 12, wherein the optical display is preferably selected from the group consisting of autostereoscopic and/or holographic displays, projection screens, displays with switchable restricted emission characteristics for privacy filters and bidirectional multiuser screens, virtual displays, head-up displays, head-mounted displays, illumination symbols, warning lamps, signal lamps, floodlights/headlights and display panels.

**17.** Security document comprising a layer construction containing a hologram according to any of Claims 1, 4-7, 11 or 12.

**Revendications**

**1.** Structure stratifiée comprenant une couche de photopolymère B présente à plat et une couche de protection C au moins partiellement durcie, pouvant être obtenue par transformation d'une composition aqueuse comprenant

(I) au moins un poly(alcool vinylique),
(II) au moins un agent de réticulation pour des poly(alcool vinylique),
(III) éventuellement au moins un promoteur d'adhérence, le promoteur d'adhérence étant de préférence au moins un hydrolysat d'un aminoalkyltrialcoxysilane, et
(IV) éventuellement au moins un tensioactif,

la couche de photopolymère B étant reliée au moins partiellement à la couche C.

**2.** Kit de pièces contenant au moins une couche de photopolymère présente à plat et une composition aqueuse pour la génération d'une couche de protection C au moins partiellement durcie, la composition aqueuse comprenant

(I) au moins un poly(alcool vinylique),
(II) au moins un agent de réticulation pour des poly(alcool vinylique),
(III) éventuellement au moins un promoteur d'adhérence, le promoteur d'adhérence étant de préférence au moins un hydrolysat d'un aminoalkyltrialcoxysilane, et
(IV) éventuellement au moins un tensioactif et

la couche de photopolymère B étant éventuellement présente sur une couche de substrat A.

**3.** Kit de pièces selon la revendication 2, contenant en outre une couche d'adhésif D et une couche de substrat E.

**4.** Structure stratifiée selon la revendication 1 ou kit de pièces selon la revendication 2 ou 3, caractérisé(e) en ce que la couche de photopolymère B est une couche de photopolymère non impressionnée comprenant

I) des polymères de matrice,
II)des monomères d'écriture,
III) des photoinitiateurs,
IV) éventuellement au moins un composant non photopolymérisable, et
V) éventuellement des catalyseurs, des stabilisateurs de radicaux, des solvants, des additifs ainsi que d'autres auxiliaires et/ou adjuvants, ou la couche de photopolymère B étant une couche de photopolymère partiellement impressionnée, contenant un hologramme, de préférence un hologramme en volume, l'hologramme en volume étant de préférence choisi dans le groupe constitué par les hologrammes en ligne, les hologrammes hors axe, les hologrammes de transfert à pleine ouverture, les hologrammes de transmission en lumière blanche, les

hologrammes de Denisyuk, les hologrammes de réflexion hors axe, les hologrammes à éclairage périphérique et les stéréogrammes holographiques.

**5.** Structure stratifiée selon la revendication 1 ou 4, **caractérisée en ce que** la structure stratifiée contient en outre une couche de substrat A, la couche de photopolymère B étant reliée sur un côté au moins partiellement avec la couche de substrat A et étant reliée sur le côté opposé au moins partiellement avec la couche de protection C.

**6.** Structure stratifiée selon la revendication 1, 4 ou 5, **caractérisée en ce que** la structure stratifiée contient en outre une couche d'adhésif D, la couche de protection C étant reliée sur un côté au moins partiellement avec la couche d'adhésif D et étant reliée sur le côté opposé au moins partiellement avec la couche de photopolymère B.

**7.** Structure stratifiée selon la revendication 6, **caractérisée en ce que** la structure stratifiée contient en outre une couche de substrat E, la couche d'adhésif D étant reliée sur un côté au moins partiellement avec la couche de substrat E et étant reliée sur la couche opposée au moins partiellement avec la couche de protection C.

**8.** Procédé pour la préparation d'une structure stratifiée selon l'une quelconque des revendications 1 ou 4 à 7, **caractérisé en ce que** d'abord une couche de protection C au moins partiellement durcie est appliquée sur une couche de photopolymère B, la couche de photopolymère B étant éventuellement présente sur une couche de substrat A, pour donner un composite stratifié B-C ou A-B-C, la couche de protection C pouvant être obtenue par transformation d'une composition aqueuse comprenant

(I) au moins un poly(alcool vinylique),
(II) au moins un agent de réticulation pour des poly(alcool vinylique),
(III) éventuellement au moins un promoteur d'adhérence, le promoteur d'adhérence étant de préférence au moins un hydrolysat d'un aminoalkyltrialcoxysilane, et
(IV) éventuellement au moins un tensioactif.

**9.** Procédé selon la revendication 8, **caractérisé en ce que**, dans une étape consécutive supplémentaire, une couche d'adhésif D est appliquée sur la couche de protection C au moins partiellement durcie, pour donner un composite stratifié B-C-D ou A-B-C-D et ensuite, dans une étape suivante supplémentaire, une couche de substrat E est appliquée sur la couche d'adhésif D, pour donner un composite stratifié B-C-D-E ou A-B-C-DE.

**10.** Procédé selon l'une quelconque des revendications 8 et 9, **caractérisé en ce qu'**un hologramme est exposé et fixé dans le composite stratifié B-C, A-B-C, B-C-D, A-B-C-D, B-C-D-E ou A-B-C-D-E.

**11.** Structure stratifiée selon l'une quelconque des revendications 1 ou 4 à 7, procédé selon l'une quelconque des revendications 8 à 10 ou kit de pièces selon l'une quelconque des revendications 2 à 4, caractérisé(e) en ce que l'au moins un poly(alcool vinylique), d'après la norme DIN 53015:2001-02, en tant que solution à 4 % en poids dans de l'eau à 20 °C, présente une viscosité de ≥ 25 mPa*s, de préférence ≥ 50 mPa*s, et le poly(alcool vinylique) présentant de préférence, d'après la norme DIN EN ISO 3681:2007-10-01, un degré d'hydrolyse de ≥ 85 % en moles, plus préférablement ≥ 95 % en moles.

**12.** Structure stratifiée selon l'une quelconque des revendications 1, 4 à 7 ou 11, procédé selon l'une quelconque des revendications 8 à 11 ou kit de pièces selon l'une quelconque des revendications de 2 à 4 ou 11, caractérisé (e) en ce que l'agent de réticulation pour les poly(alcool vinylique) est choisi dans le groupe constitué par une solution aqueuse de glyoxal, le glutaraldéhyde, l'acide oxalique, la N,N'-diméthylurée, l'hydroxyde de magnésium, l'hydroxyde de calcium, l'acide borique, des sels d'acide borique, des aluminates, le sulfate d'aluminium, l'acide silicique, un ester d'acide silicique et/ou des combinaisons d'au moins deux de ceux-ci.

**13.** Utilisation du kit de pièces selon l'une quelconque des revendications 2 à 4, 11 et 12 ou de la structure stratifiée selon l'une quelconque des revendications 1, 4 à 7, 11 et 12 pour le procédé selon l'une quelconque des revendications 8 à 12.

**14.** Utilisation d'une couche de protection C au moins partiellement durcie pour la production d'une couche de photopolymère B, la couche de protection C pouvant être obtenue par transformation d'une composition aqueuse comprenant

(I) au moins un poly(alcool vinylique),

(II) au moins un agent de réticulation pour des poly(alcool vinylique),
(III) éventuellement au moins un promoteur d'adhérence, le promoteur d'adhérence étant de préférence au moins un hydrolysat d'un aminoalkyltrialcoxysilane, et
(IV) éventuellement au moins un tensioactif.

**15.** Utilisation de la structure stratifiée selon l'une quelconque des revendications 1, 4 à 7, 11 et 12 en tant que support d'enregistrement holographique.

**16.** Affichage optique, comprenant une structure stratifiée contenant un hologramme selon l'une quelconque des revendications 1, 4 à 7, 11 et 12, l'affichage optique étant de préférence choisi dans le groupe constitué par des affichages autostéréoscopiques et/ou holographiques, des écrans de projection, des disques de projection, des affichages dotés de comportements de rayonnement limités commutables pour des filtres de confidentialité et des écrans multi-utilisateurs bidirectionnels, des écrans virtuels, des affichages tête haute, des affichages portés sur la tête, des symboles lumineux, des lampes d'avertissement, des projecteurs et des panneaux.

**17.** Document de sécurité, comprenant une structure stratifiée contenant un hologramme selon l'une quelconque des revendications 1, 4 à 7, 11 et 12.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2011054797 A
- WO 2011067057 A
- WO 2017081078 A
- US 4994347 A
- EP 0223587 A
- WO 2012062655 A
- US 2012062658 A
- WO 2015091427 A


### In der Beschreibung aufgeführte Nicht-Patentliteratur


- **CUNNINGHAM et al.** *RadTech'98 North America UV/EB Conference Proceedings,* 19. April 1998
- Chemistry & Technology of UV & EB Formulations For Coatings. Inks & Paints. SITA Technology, 1991, vol. 3, 61-328